# EUROPEAN PATENT APPLICATION

(11) **EP 4 518 613 A2**
(43) Date of publication of application: **05.03.2025**
(21) Application number: 24178583.1
(22) Date of filing: 28.05.2024
(51) Int. Cl.: H10D 62/10, H10D 30/43, H10D 84/01, H10D 84/03, H10D 84/83

(54) **SEMICONDUCTOR DEVICE**

(30) Priority: 31.08.2023 KR 20230115137
(71) Applicant: Samsung Electronics Co., Ltd., Suwon-si, Gyeonggi-do 16677 (KR)
(72) Inventor: HWANG, Dong Hoon, 16677 Suwon-si (KR); KIM, Hyo Jin, 16677 Suwon-si (KR); MOON, Byung Ho, 16677 Suwon-si (KR); PARK, Kyoung-Mi, 16677 Suwon-si (KR); CHO, Kyung Hee, 16677 Suwon-si (KR)
(74) Representative: Marks & Clerk LLP

(57) **Abstract**

A semiconductor device that includes a lower pattern (BP1) extending in a first direction (D1), a first channel pattern (CH1) on the lower pattern, and includes a plurality of first sheet patterns (NS1), a second channel pattern (CH2) on the lower pattern, includes a plurality of second sheet patterns (NS2) and spaced apart from the first channel pattern, a first gate structure (GS1) which extends around the first sheet pattern, and includes a first gate electrode (120) and a first gate insulating film (130), a second gate structure (GS2) which extends around the second sheet pattern, and includes a second gate electrode (220) and a second gate insulating film (230), a first gate capping pattern (145) and a second gate capping pattern (245). The number of first sheet patterns is different from the number of second sheet patterns, and a thickness of the first gate capping pattern is different from a thickness of the second gate capping pattern.

## Description

### BACKGROUND

The present disclosure relates to a semiconductor device, and more specifically to, a semiconductor device including an MBCFET^{™} (Multi-Bridge Channel Field Effect Transistor) and a method for manufacturing the same.

As one of scaling technologies for enhancing the density of a semiconductor device, a multi gate transistor in which a multi-channel active pattern (or a silicon body) having a fin or nanowire shape is formed on a substrate and a gate is formed on a surface of the multi-channel active pattern has been proposed.

Since such a multi gate transistor utilizes a three-dimensional channel, scaling is easily performed. Further, even if a gate length of the multi gate transistor is not increased, the current control capability may be improved. Furthermore, a SCE (short channel effect) in which potential of a channel region is influenced by a drain voltage may be effectively suppressed.

### SUMMARY

Aspects of the present disclosure provide a semiconductor device that may improve element performance and reliability.

However, embodiments of the present disclosure are not restricted to the one set forth herein. The above and other aspects of the present disclosure will become more apparent to one of ordinary skill in the art to which the present disclosure pertains by referencing the detailed description of the present disclosure given below.

According to some embodiments of the present disclosure, there is provided a semiconductor device including a lower pattern that extends in a first direction, a first channel pattern on the lower pattern, and includes a plurality of first sheet patterns spaced apart in a second direction, a second channel pattern on the lower pattern, includes a plurality of second sheet patterns spaced apart in the second direction, and is spaced apart from the first channel pattern in the first direction, a first gate structure which extends around the first sheet pattern in a plane including the first direction and the second direction, and includes a first gate electrode and a first gate insulating film, a second gate structure which extends around the second sheet pattern in the plane including the first direction and the second direction, and includes a second gate electrode and a second gate insulating film, a first gate capping pattern on the first gate structure, and a second gate capping pattern on the second gate structure. A number of first sheet patterns is different from the number of second sheet patterns, and a thickness of the first gate capping pattern is different from a thickness of the second gate capping pattern.

According to some embodiments of the present disclosure, there is provided a semiconductor device including a lower pattern that extends in a first direction, a first channel pattern on the lower pattern, and includes a plurality of first sheet patterns spaced apart in a second direction, a second channel pattern on the lower pattern, includes a plurality of second sheet patterns spaced apart in the second direction, and is spaced apart from the first channel pattern in the first direction, a first gate electrode which extends around the first sheet pattern in a plane including the first direction and the second direction, a second gate electrode which extends around the second sheet pattern in the plane including the first direction and the second direction, a first gate capping pattern on the first gate electrode, a second gate capping pattern on the second gate electrode, a first gate contact which extends into the first gate capping pattern and is electrically connected to the first gate electrode, and a second gate contact which extends into the second gate capping pattern and is electrically connected to the second gate electrode. The number of first sheet patterns is different from the number of second sheet patterns. The first gate electrode includes a first portion of the first gate electrode that overlaps the first channel pattern in the second direction, and the second gate electrode includes a first portion of the second gate electrode that overlaps the second channel pattern in the second direction, and a distance from an upper surface of the lower pattern to an upper surface of the first portion of the first gate electrode is different from a distance from an upper surface of the lower pattern to an upper surface of the first portion of the second gate electrode.

At least some of the above and other features of the invention are set out in the claims.

### BRIEF DESCRIPTION OF DRAWINGS

The above and other aspects and features of the present disclosure will become more apparent by describing in detail illustrative embodiments thereof with reference to the attached drawings, in which:
FIG. 1 is an example plan view for explaining a semiconductor device according to some embodiments;
FIG. 2 is a cross-sectional view taken along line A-A of FIG. 1;
FIG. 3 is a cross-sectional view taken along lines B-B, C-C, and D-D in FIG. 1;
FIG. 4 is a cross-sectional view taken along lines E-E, F-F and G-G of FIG. 1;
FIGS. 5 to 7 are enlarged views showing a region P, a region Q, and a region R of FIG. 3, respectively;
FIGS. 8 to 11 are diagrams for explaining a semiconductor device according to some embodiments, respectively;
FIGS. 12 to 14 are diagrams for explaining a semiconductor device according to some embodiments;
FIGS. 15 and 16 are diagrams for explaining a semiconductor device according to some embodiments;
FIGS. 17 to 34 are intermediate stage diagrams for explaining a method for manufacturing a semiconductor device according to some embodiments.

### DETAILED DESCRIPTION

Although terms such as first and second are used to describe various elements or components in the present specification, it goes without saying that these elements or components are not limited by these terms. These terms are only used to distinguish a single element or component from other elements or components. Therefore, it goes without saying that a first element or component referred to below may be a second element or component within the technical idea of the present disclosure. Furthermore, the following examples are described with reference to directions (e.g. labelled D1, D2, D3). It will be understood that these are example directions relative to a device, and do not imply any particular orientation of that device.

The semiconductor device according to some embodiments may include a tunneling transistor (tunneling FET), a three-dimensional (3D) transistor or a transistor based on two-dimensional material (2D material based FETs) and a heterostructure thereof. Further, the semiconductor device according to some embodiments may also include a bipolar junction transistor, a laterally diffused metal oxide semiconductor (LDMOS), or the like.

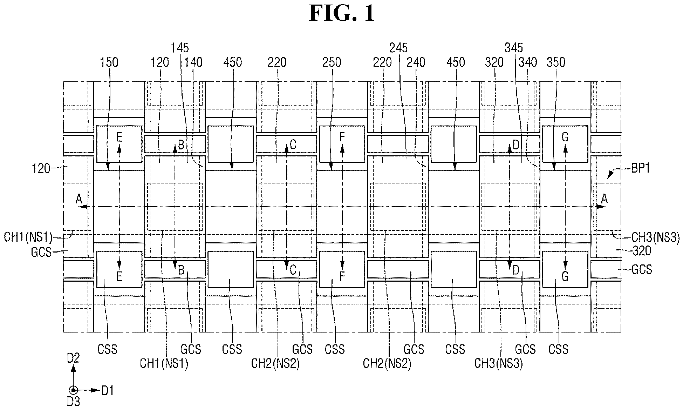

The semiconductor device according to some embodiments will be described with reference to FIGS. 1 to 7.

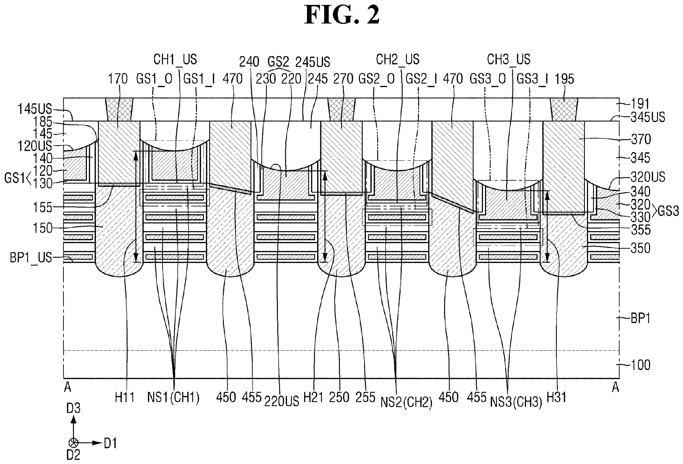

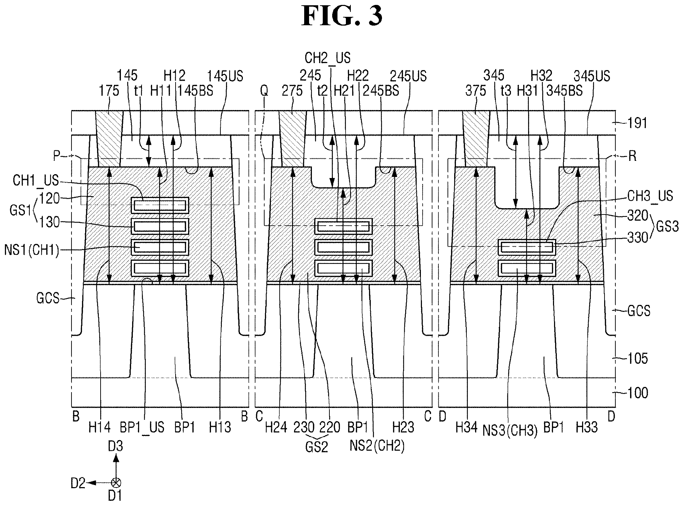

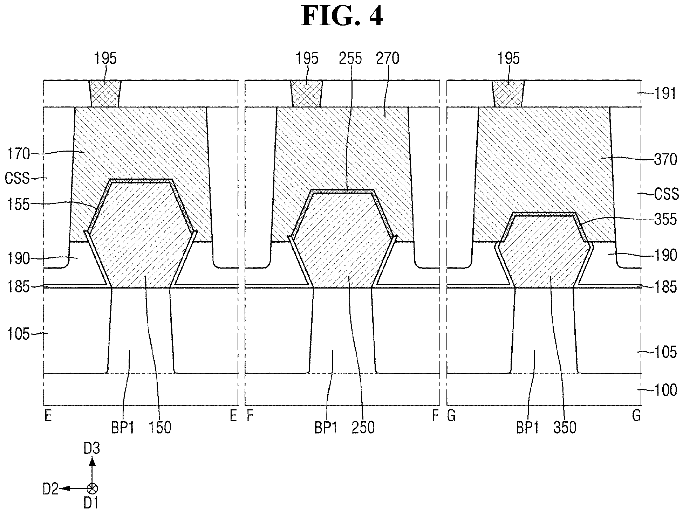

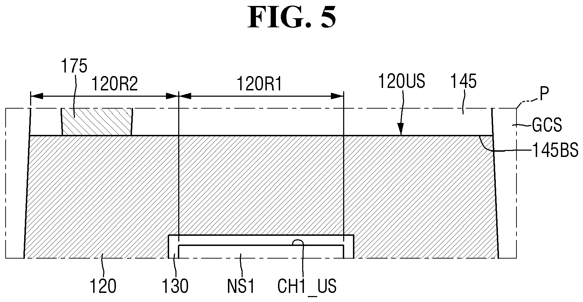

FIG. 1 is an example plan view for explaining a semiconductor device according to some embodiments. FIG. 2 is a cross-sectional view taken along line A-A of FIG. 1. FIG. 3 is a cross-sectional view taken along lines B-B, C-C, and D-D in FIG. 1. FIG. 4 is a cross-sectional view taken along lines E-E, F-F and G-G of FIG. 1. FIGS. 5 to 7 are enlarged views showing a region P, a region Q, and a region R of FIG. 3, respectively.

For reference, FIG. 1 is simply shown without illustrating first to third gate insulating films 130, 230, and 330, first to third gate contacts 175, 275, and 375, a source/drain via 195, and the like.

Referring to FIGS. 1 to 7, the semiconductor device according to some embodiments may include a first lower pattern BP1, first to third channel patterns CH1, CH2, and CH3, and first to third gate structures GS1, GS2, and GS3, first to third gate capping patterns 145, 245, 345, first to fourth source/drain patterns 150, 250, 350, and 450, and first to third gate contacts 175, 275, and 375.

The substrate 100 may be bulk silicon or silicon-on-insulator (SOI). In some embodiments, the substrate 100 may be a silicon substrate or may include, but not limited to, silicon germanium, SGOI (silicon germanium on insulator), indium antimonide, lead tellurium compounds, indium arsenide, indium phosphide, gallium arsenide or gallium antimonide.

A first lower pattern BP1 may protrude from the substrate 100 in a third direction D3. The first lower pattern BP1 may extend long in a first direction D1. The first lower pattern BP1 may be a fin-shaped pattern.

As an example, the first lower pattern BP1 may be disposed in a PMOS formation region. As another example, the first lower pattern BP1 may be disposed in a NMOS formation region.

The first lower pattern BP1 may be formed by etching a part of the substrate 100, and may include an epitaxial layer grown from the substrate 100. The first lower pattern BP1 may include silicon or germanium, which is an elemental semiconductor material. Further, the first lower pattern BP1 may include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge), and tin (Sn), or a compound obtained by doping these elements with a group IV element.

The group III-V compound semiconductor may be, for example, one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

A field insulating film 105 may be disposed on the substrate 100. The field insulating film 105 may be disposed on a side wall of the first lower pattern BP1. The field insulating film 105 is not disposed on an upper surface BP1_US of the first lower pattern.

The field insulating film 105 may entirely cover, overlap, or be on the side walls of the first lower pattern BP1. Unlike the shown example, the field insulating film 105 may cover a part of the side wall of the first lower pattern BP1. In such a case, a part of the first lower pattern BP1 may protrude beyond the upper surface of the field insulating film 105 in the third direction D3.

Although the upper surface of the field insulating film 105 is shown as a plane, the embodiment is not limited thereto. Unlike the shown example, the upper surface of the field insulating film 105 may have a concave shape. The field insulating film 105 may include, for example, an oxide film, a nitride film, an oxynitride film or a combined film thereof. Although the field insulating film 105 is shown as being a single film, this is only for convenience of explanation, and the embodiments are not limited thereto.

At least one or more first channel patterns CH1 may be disposed on the first lower pattern BP1. At least one or more second channel patterns CH2 may be disposed on the first lower pattern BP1. At least one or more third channel patterns CH3 may be disposed on the first lower pattern BP1.

The first channel pattern CH1, the second channel pattern CH2, and the third channel pattern CH3 may each be disposed on the upper surface BP1_US of the first lower pattern. The first channel pattern CH1, the second channel pattern CH2, and the third channel pattern CH3 may each overlap the first lower pattern BP1 in the third direction D3. The first channel pattern CH1, the second channel pattern CH2, and the third channel pattern CH3 may each be spaced apart from the first lower pattern BP1 in the third direction D3.

The first channel pattern CH1 is spaced apart from the second channel pattern CH2 and the third channel pattern CH3 in the first direction D1. The first channel patterns CH1 may be spaced apart from each other in the first direction D1. The second channel pattern CH2 is spaced apart from the third channel pattern CH3 in the first direction D1. The second channel patterns CH2 may be spaced apart from each other in the first direction D1. The third channel patterns CH3 may be spaced apart from each other in the first direction D1.

The first channel pattern CH1 may include a plurality of first sheet patterns NS1. The plurality of first sheet patterns NS1 may be disposed on the upper surface BP1_US of the first lower pattern. The plurality of first sheet patterns NS1 are arranged on the first lower pattern BP1 in the third direction D3. Each first sheet pattern NS1 may be spaced apart in the third direction D3.

The second channel pattern CH2 may include a plurality of second sheet patterns NS2. The plurality of second sheet patterns NS2 may be disposed on the upper surface BP1_US of the first lower pattern. The plurality of second sheet patterns NS2 are arranged on the first lower pattern BP1 in the third direction D3. Each second sheet pattern NS2 may be spaced apart in the third direction D3.

The third channel pattern CH3 may include a plurality of third sheet patterns NS3. The plurality of third sheet patterns NS3 may be disposed on the upper surface BP1_US of the first lower pattern. The plurality of third sheet patterns NS3 are arranged on the first lower pattern BP1 in the third direction D3. Each third sheet pattern NS3 may be spaced apart in the third direction D3. The third direction D3 may be a direction that intersects the first direction D1 and the second direction D2. For example, the third direction D3 may be a thickness direction of the substrate 100. The first direction D1 may be a direction that intersects the second direction D2.

The number of first sheet patterns NS1 may be different from the number of second sheet patterns NS2 and the number of third sheet patterns NS3. The number of second sheet patterns NS2 may be different from the number of third sheet patterns NS3. For example, the number of first sheet patterns NS1 included in the first channel pattern CH1 may be larger than the number of second sheet patterns NS2 included in the second channel pattern CH2. The number of first sheet patterns NS1 included in the first channel pattern CH1 may be larger than the number of third sheet patterns NS3 included in the third channel pattern CH3. The number of second sheet patterns NS2 included in the second channel pattern CH2 may be larger than the number of third sheet patterns NS3 included in the third channel pattern CH3.

Although each of the first to third channel patterns CH1, CH2, and CH3 is shown to include a plurality of sheet patterns, the embodiments are not limited thereto. Unlike the shown example, the number of third sheet patterns NS3 included in the third channel pattern CH3 may be one.

The first channel pattern CH1 may include, but not limited to, one more sheet patterns than the second channel pattern CH2. The second channel pattern CH2 may include, but not limited to, one more sheet patterns than the third channel pattern CH3.

Although the second channel pattern CH2 is shown as being disposed between the first channel pattern CH1 and the third channel pattern CH3, this is only for convenience of explanation, and the embodiment is not limited thereto. The first channel pattern CH1 may, for example, be disposed between the second channel pattern CH2 and the third channel pattern CH3 .

Each of the first to third sheet patterns NS1, NS2, and NS3 may include an upper surface and a lower surface. Taking the first sheet pattern NS1 as an example, the upper surface of the first sheet pattern NS1 may be opposite to the lower surface of the first sheet pattern NS1 in the third direction D3. The lower surface of the first sheet pattern NS1 faces the upper surface BP1_US of the first lower pattern.

The upper surface CH1_US of the first channel pattern may be the upper surface of the first sheet pattern NS1 located at the uppermost part of the first sheet pattern NS1 included in the first channel pattern CH1. An upper surface CH2_US of the second channel pattern may be an upper surface of the second sheet pattern NS2 located at the uppermost part of the second sheet pattern NS2 included in the second channel pattern CH2. An upper surface CH3_US of the third channel pattern may be an upper surface of the third sheet pattern NS3 located at the uppermost part of the third sheet pattern NS3 included in the third channel pattern CH3. A height or distance from the upper surface BP1_US of the first lower pattern to the upper surface CH2_US of the second channel pattern is smaller than or less than a height or distance from the upper surface BP1_US of the first lower pattern to the upper surface CH1_US of the first channel pattern. A height or distance from the upper surface BP1_US of the first lower pattern to the upper surface CH2_US of the second channel pattern is larger than or greater than a height or distance from the upper surface BP1_US of the first lower pattern to the upper surface CH3_US of the third channel pattern.

The first to third sheet patterns NS1, NS2, and NS3 may include one of silicon or germanium which is an elemental semiconductor material, a group IV-IV compound semiconductor or a group III-V compound semiconductor. The first sheet pattern NS1 includes the same material as the second sheet pattern NS2. The first sheet pattern NS1 includes the same material as the third sheet pattern NS3.

The first sheet pattern NS1 may include the same material as the first lower pattern BP1, or may include a material different from the first lower pattern BP1. In the semiconductor device according to some embodiments, the first lower pattern BP1 may be a silicon lower pattern including silicon. The first to third sheet patterns NS1, NS2, and NS3 may each be silicon sheet patterns including silicon.

A width of the first sheet pattern NS1 in the second direction D2 may increase or decrease in proportion to a width of the upper surface BP1_US of the first lower pattern in the second direction D2. Although the widths in the second direction D2 of the first sheet patterns NS1 stacked in the third direction D3 are shown as being the same, this is only for convenience of explanation, and the embodiment is not limited thereto. Unlike the shown example, the width of the first sheet patterns NS1 stacked in the third direction D3 in the second direction D2 may decrease as it goes away from the first lower pattern BP1. The above explanation is also applicable to the second sheet pattern NS2 and the third sheet pattern NS3.

Although it has been described above that the three channel patterns CH1, CH2, and CH3 including different numbers of sheet patterns are disposed on the first lower pattern BP1, the embodiment is not limited thereto. Unlike the shown example, as an example, two channel patterns including different numbers of sheet patterns may be disposed on the first lower pattern BP1. As another example, four or more channel patterns including different numbers of sheet patterns may be disposed on the first lower pattern BP1.

The first to third gate structures GS1, GS2, and GS3 may each be disposed on the first lower pattern BP1. Each of the first to third gate structures GS1, GS2, and GS3 may intersect the first lower pattern BP1. The first to third gate structures GS1, GS2, and GS3 may each be in contact with the upper surface BP1_US of the first lower pattern.

The first gate structure GS1 may be spaced apart from the second gate structure GS2 and the third gate structure GS3 in the first direction D1. The second gate structure GS2 may be spaced apart from the third gate structure GS3 in the first direction D1.

The first gate structure GS1 may surround the first channel pattern CH1 in a cross-sectional plane of the first direction D1 and the second direction D2. As used herein, the term "surround" may be interpreted as extending around, but may not completely surround. That is to say, "surround" may refer to a partial or complete surrounding. The first gate structure GS1 may surround each first sheet pattern NS1 in a cross-sectional plane across the first direction D1 and the second direction D2.

The first gate structure GS1 may include a first inner gate structure GS1_I and a first outer gate structure GS1_O. The first inner gate structure GS1_I may be disposed between the first sheet patterns NS1 adjacent in the third direction D3, and between the first lower pattern BP1 and the first sheet pattern NS1. The first outer gate structure GS1_O may be disposed on the upper surface CH1_US of the first channel pattern. For example, the first inner gate structure GS1_I and the first outer gate structure GS1_O may be defined from viewpoint of a cross-sectional view as in FIG. 2.

The second gate structure GS2 may surround the second channel pattern CH2 in a cross-sectional plane of the first direction D1 and the second direction D2. The second gate structure GS2 may surround each second sheet pattern NS2 in a cross-sectional plane of the first direction D1 and the second direction D2.

The second gate structure GS2 may include a second inner gate structure GS2_I and a second outer gate structure GS2_O. The second inner gate structure GS2_I may be disposed between the second sheet patterns NS2 adjacent to each other in the third direction D3, and between the first lower pattern BP1 and the second sheet pattern NS2. The second outer gate structure GS2_O may be disposed on the upper surface CH2_US of the second channel pattern.

The third gate structure GS3 may surround the third channel pattern CH3 in a cross-sectional plane of the first direction D1 and the second direction D2. The third gate structure GS3 may surround each third sheet pattern NS3 in a cross-sectional plane of the first direction D1 and the second direction D2.

The third gate structure GS3 may include a third inner gate structure GS3_I and a third outer gate structure GS3_O. The third inner gate structure GS3_I may be disposed between the third sheet patterns NS3 adjacent to each other in the third direction D3, and between the first lower pattern BP1 and the third sheet pattern NS3. The third outer gate structure GS3_O may be disposed on the upper surface CH3_US of the third channel pattern.

The first gate structure GS1 may include a first gate electrode 120 and a first gate insulating film 130. The first inner gate structure GS1_I and the first outer gate structure GS1_O each include a first gate electrode 120 and a first gate insulating film 130.

The first gate electrode 120 may be disposed on the first lower pattern BP1. From the viewpoint of a cross-sectional view, the first gate electrode 120 may surround each first sheet pattern NS1. The first gate insulating film 130 may be disposed between the first gate electrode 120 and the first channel pattern CH1. The first gate insulating film 130 may be disposed between the first gate electrode 120 and the first sheet pattern NS1.

The second gate structure GS2 may include a second gate electrode 220 and a second gate insulating film 230. The second inner gate structure GS2_I and the second outer gate structure GS2_O each include a second gate electrode 220 and a second gate insulating film 230. The second gate electrode 220 may be disposed on the first lower pattern BP1. From viewpoint of a cross-sectional view, the second gate electrode 220 may surround each second sheet pattern NS2. The second gate insulating film 230 may be disposed between the second gate electrode 220 and the second sheet pattern NS2.

The third gate structure GS3 may include a third gate electrode 320 and a third gate insulating film 330. The third inner gate structure GS3_I and the third outer gate structure GS3_O each include the third gate electrode 320 and the third gate insulating film 330. The third gate electrode 320 may be disposed on the first lower pattern BP1. From viewpoint of a cross-sectional view, the third gate electrode 320 may surround each third sheet pattern NS3. The third gate insulating film 330 may be disposed between the third gate electrode 320 and the third sheet pattern NS3.

The first to third gate insulating films 130, 230, and 330 may each extend along the upper surface of the field insulating film 105 and the upper surface BP1_US of the first lower pattern. The first to third gate insulating films 130, 230, and 330 may each be in contact with the upper surface of the field insulating film 105 and the upper surface BP1_US of the first lower pattern.

Although the upper surface 120US of the first gate electrode, the upper surface 220US of the second gate electrode, and the upper surface 320US of the third gate electrode are shown as being a concave curved surface in the cross-sectional view as in FIG. 2, the embodiment is not limited thereto. The upper surface 120US of the first gate electrode, the upper surface 220US of the second gate electrode, and the upper surface 320US of the third gate electrode may be a plane.

In FIGS. 3 and 5, the first gate electrode 120 may include a first portion 120R1 and a second portion 120R2. The first portion 120R1 of the first gate electrode is directly connected to the second portion 120R2 of the first gate electrode. The second portion 120R2 of the first gate electrode may be located on both sides of the first portion 120R1 of the first gate electrode. Unlike the upper surface 220US of the second gate electrode and the upper surface 320US of the third gate electrode, the upper surface 120US of the first gate electrode may be flat. In such a case, the first portion 120R1 of the first gate electrode may overlap the first channel pattern CH1 in the third direction D3. For example, the first portion 120R1 of the first gate electrode may be a portion of the first gate electrode 120 that overlaps the upper surface CH1_US of the first channel pattern in the third direction D3. The second portion 120R2 of the first gate electrode may not overlap the first channel pattern CH1 in the third direction D3.

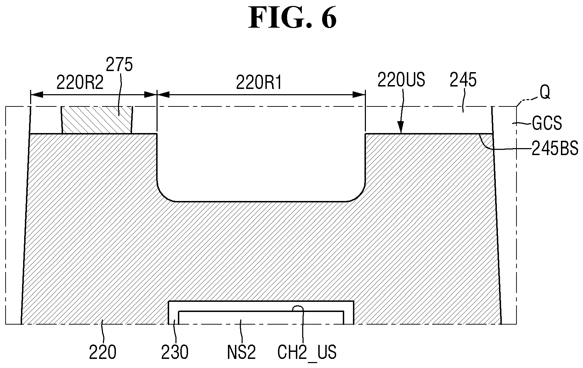

In FIGS. 3 and 6, the second gate electrode 220 may include a first portion 220R1 and a second portion 220R2. The first portion 220R1 of the second gate electrode is directly connected to the second portion 220R2 of the second gate electrode. The second portion 220R2 of the second gate electrode may be located on both sides of the first portion 220R1 of the second gate electrode. The upper surface 220US of the second gate electrode may include a region that is recessed toward the second channel pattern CH2. The first portion 220R1 of the second gate electrode may be a region in which a part of the second gate electrode 220 is recessed. The first portion 220R1 of the second gate electrode may overlap the second channel pattern CH2 in the third direction D3. The first portion 220R1 of the second gate electrode may overlap the upper surface CH2_US of the second channel pattern in the third direction D3. The second portion 220R2 of the second gate electrode may not overlap the second channel pattern CH2 in the third direction D3.

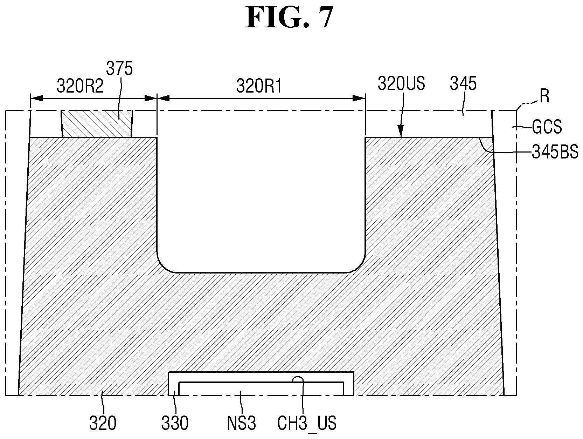

In FIGS. 3 and 7, the third gate electrode 320 may include a first portion 320R1 and a second portion 320R2. The first portion 320R1 of the third gate electrode is directly connected to the second portion 320R2 of the third gate electrode. The second portion 320R2 of the third gate electrode may be located on both sides of the first portion 320R1 of the third gate electrode. The upper surface 320US of the third gate electrode may include a region that is recessed toward the third channel pattern CH3. The first portion 320R1 of the third gate electrode may be a region in which a part of the third gate electrode 320 is recessed. The first portion 320R1 of the third gate electrode may overlap the third channel pattern CH3 in the third direction D3. The first portion 320R1 of the third gate electrode may overlap the upper surface CH3_US of the third channel pattern in the third direction D3. The second portion 320R2 of the third gate electrode may not overlap the third channel pattern CH3 in the third direction D3.

A height H11 from the upper surface BP1_US of the first lower pattern to the upper surface 120US of the first portion 120R1 of the first gate electrode may be different from a height H21 from the upper surface BP1_US of the first lower pattern to the upper surface 220US of the first portion 220R1 of the second gate electrode. For example, the height H1 1 from the upper surface BP1_US of the first lower pattern to the upper surface 120US of the first portion 120R1 of the first gate electrode is larger than the height H21 from the upper surface BP1_US of the first lower pattern to the upper surface 220US of the first portion 220R1 of the second gate electrode. The height H21 from the upper surface BP1_US of the first lower pattern to the upper surface 220US of the first portion 220R1 of the second gate electrode is larger than a height H31 from the upper surface BP1_US of the first lower pattern to the upper surface 320US of the first portion 320R1 of the third gate electrode. The second gate electrode 220 will be explained as an example. The height H21 from the upper surface BP1_US of the first lower pattern to the upper surface 220US of the first portion 220R1 of the second gate electrode is measured on a line passing through the center of the upper surface CH2_US of the second channel pattern.

For example, the height H21 from the upper surface BP1_US of the first lower pattern to the upper surface 220US of the first portion 220R1 of the second gate electrode may be a height H21 from the upper surface BP1_US of the first lower pattern to the upper surface 220US of the second gate electrode in FIG. 2.

The height H13 from the upper surface BP1_US of the first lower pattern to the upper surface 120US of the second portion 120R2 of the first gate electrode may be the same as the height H23 from the upper surface BP1_US of the first lower pattern to the upper surface 220US of the second portion 220R2 of the second gate electrode. The height H23 from the upper surface BP1_US of the first lower pattern to the upper surface 220US of the second portion 220R2 of the second gate electrode may be the same as the height H33 from the upper surface BP1_US of the first lower pattern to the upper surface 320US of the second portion 320R2 of the third gate electrode. Here, the meaning of "same height" will be understood by a skilled person as including not only a case where the heights are exactly the same at the two positions to be compared, but also a small (or minute) difference in height that may occur due to process margins or the like. For example, "same height" may be interpreted as meaning that the heights are substantially the same, and/or functionally the same.

When the upper surface 120_US of the first gate electrode is a plane as shown in FIG. 3, the height H11 from the upper surface BP1_US of the first lower pattern to the upper surface 120US of the first portion 120R1 of the first gate electrode may be the same as the height H13 from the upper surface BP1_US of the first lower pattern to the upper surface 120US of the second portion 120R2 of the first gate electrode. Unlike the shown example, when the upper surface 120_US of the first gate electrode has a concave shape, the height H11 from the upper surface BP1_US of the first lower pattern to the upper surface 120US of the first portion 120R1 of the first gate electrode may be smaller than or less than the height H13 from the upper surface BP1_US of the first lower pattern to the upper surface 120US of the second portion 120R2 of the first gate electrode.

In FIGS. 3, 6, and 7, the height H21 from the upper surface BP1_US of the first lower pattern to the upper surface 220US of the first portion 220R1 of the second gate electrode is smaller than or less than the height H23 from the upper surface BP1_US of the first lower pattern to the upper surface 220US of the second portion 220R2 of the second gate electrode. The height H31 from the upper surface BP1_US of the first lower pattern to the upper surface 320US of the first portion 320R1 of the third gate electrode is smaller than or less than the height H33 from the upper surface BP1_US of the first lower pattern to the upper surface 320US of the second portion 320R2 of the third gate electrode.

The first gate structure GS 1 and the second gate structure GS2 will be explained as an example. From viewpoint of a cross-sectional view as in FIG. 2, when the upper surface 220US of the second gate electrode is located at the same height level as the upper surface 120US of the first gate electrode, an area in which a second source/drain contact 270 and the second outer gate structure GS2_O face each other is larger than an area in which a first source/drain contact 170 and the first outer gate structure GS1_O face each other. Accordingly, the capacitance between the second source/drain contact 270 and the second outer gate structure GS2_O becomes larger than the capacitance between the first source/drain contact 170 and the first outer gate structure GS1_O. A large capacitance between the outer gate structure and the source/drain contact may interfere with the operation of the semiconductor device that requires high speed driving. Accordingly, the performance and reliability of the semiconductor device may be degraded.

Meanwhile, since the upper surface 220US of the second gate electrode becomes lower than the upper surface 120US of the first gate electrode, the capacitance between the second source/drain contact 270 and the second outer gate structure GS2_O may decrease. That is, the performance and reliability of the semiconductor device may be improved.

The first to third gate electrodes 120, 220, and 320 may include at least one of metal, metal alloy, conductive metal nitride, metal silicide, doped semiconductor material, conductive metal oxide and/or conductive metal oxynitride. The first to third gate electrodes 120, 220, and 320 may include, but not limited to, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and/or combinations thereof. The conductive metal oxide and conductive metal oxynitride may include, but not limited to, an oxidized form of the aforementioned materials.

The first to third gate insulating films 130, 230, and 330 may include silicon oxide, silicon oxynitride, silicon nitride or a high dielectric constant material having a higher dielectric constant than silicon oxide. The high dielectric constant material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the first to third gate insulating films 130, 230, and 330 are shown as a single film, this example is only for convenience of explanation and is not limited thereto. The first to third gate insulating films 130, 230, and 330 may each include a plurality of films. The first gate insulating film 130 will be described as an example. The first gate insulating film 130 may include an interfacial layer and a high dielectric constant insulating film disposed between the first channel pattern CH1 and the first gate electrode 120. For example, the interfacial layer may not be formed along the profile of the upper surface of the field insulating film 105.

The semiconductor device according to some embodiments may include an NC (Negative Capacitance) FET that uses a negative capacitor. For example, the first to third gate insulating films 130, 230, and 330 may each include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitances may be larger than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and/or lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and/or oxygen (O).

The ferroelectric material film may further include a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and/or yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, silicon oxide and a metal oxide having a high dielectric constant. The metal oxide included in the paraelectric material film may include, for example, but not limited to, at least one of hafnium oxide, zirconium oxide, and/or aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. A thickness of the ferroelectric material film may be, for example, but not limited to, 0.5 to 10 nm. Since a critical thickness that exhibits the ferroelectric properties may vary for each ferroelectric material, the thickness of the ferroelectric material film may vary depending on the ferroelectric material.

As an example, the first to third gate insulating films 130, 230, and 330 may each include one ferroelectric material film. As another example, the first to third gate insulating films 130, 230, and 330 may include a plurality of ferroelectric material films spaced apart from each other. The first to third gate insulating films 130, 230, and 330 may each have a stacked film structure in which the plurality of ferroelectric material films and the plurality of paraelectric material films are alternately stacked.

A first gate spacer 140 may be disposed on a side wall of the first gate structure GS1. A second gate spacer 240 may be disposed on a side wall of the second gate structure GS2. A third gate spacer 340 may be disposed on a side wall of the third gate structure GS3.

In a cross-sectional view as in FIG. 2, the first gate structure GS1 may not enter between the first gate spacer 140 and the first channel pattern CH1. The first outer gate structure GS1_O may be disposed between the first gate spacers 140.

In the semiconductor device according to some embodiments, a part of the second gate structure GS2 may enter between or be between the second gate spacer 240 and the second channel pattern CH2. A part of the third gate structure GS3 may enter between or be between the third gate spacer 340 and the third channel pattern CH3.

In the cross-sectional view as in FIG. 2, the second gate spacer 240 may have a shape that rests on the second outer gate structure GS2_O. A part of the second outer gate structure GS2_O may enter between or be between the second gate spacer 240 and the second channel pattern CH2. The third gate spacer 340 may have a shape that rests on the third outer gate structure GS3_O. A part of the third outer gate structure GS3_O may enter between or be between the third gate spacer 340 and the third channel pattern CH3.

The first to third gate spacers 140, 240, and 340 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and/or combinations thereof. Although the first to third gate spacers 140, 240, and 340 are shown to be a single film, this embodiment is only for convenience of explanation and is not limited thereto.

A first gate capping pattern 145 may be disposed on the first gate structure GS1. The first gate capping pattern 145 may be disposed on the upper surface 120US of the first gate electrode. The first gate capping pattern 145 may include a lower surface 145BS and an upper surface 145US that are opposite to each other in the third direction D3. The lower surface 145BS of the first gate capping pattern faces the first gate electrode 120. The lower surface 145BS of the first gate capping pattern may be in contact with the upper surface 120US of the first gate electrode.

A second gate capping pattern 245 may be disposed on the second gate structure GS2. The second gate capping pattern 245 may be disposed on the upper surface 220US of the second gate electrode. The second gate capping pattern 245 may include a lower surface 245BS and an upper surface 245US that are opposite to each other in the third direction D3. The lower surface 245BS of the second gate capping pattern faces the second gate electrode 220. The lower surface 245BS of the second gate capping pattern may be in contact with the upper surface 220US of the second gate electrode.

A third gate capping pattern 345 may be disposed on the third gate structure GS3. The third gate capping pattern 345 may be disposed on the upper surface 320US of the third gate electrode. The third gate capping pattern 345 may include a lower surface 345BS and an upper surface 345US that are opposite to each other in the third direction D3. The lower surface 345BS of the third gate capping pattern faces the third gate electrode 320. The lower surface 345BS of the third gate capping pattern may be in contact with the upper surface 320US of the third gate electrode.

The upper surface 145US of the first gate capping pattern may be disposed on the same plane with the upper surface 245US of the second gate capping pattern. The upper surface 145US of the first gate capping pattern may be disposed on the same plane with the upper surface 345US of the third gate capping pattern. A height H12 from the upper surface BP1_US of the first lower pattern to the upper surface 145US of the first gate capping pattern may be the same as a height H22 from the upper surface BP1_US of the first lower pattern to the upper surface 245US of the second gate capping pattern. The height H12 from the upper surface BP1_US of the first lower pattern to the upper surface 145US of the first gate capping pattern may be the same as a height H32 from the upper surface BP1_US of the first lower pattern to the upper surface 345US of the third gate capping pattern.

For example, the height H21 from the upper surface BP1_US of the first lower pattern to the upper surface 220US of the first portion 220R1 of the second gate electrode may be the height from the upper surface BP1_US of the first lower pattern to the lower surface 245BS of the second gate capping pattern.

The second gate capping pattern 245 will be explained as an example. A thickness t2 of the second gate capping pattern 245 may be a thickness of the second gate capping pattern 245 at a portion in which the second gate capping pattern 245 overlaps the second channel pattern CH2 in the third direction D3. For example, the thickness t2 of the second gate capping pattern 245 may be measured on a line passing through the center of the upper surface CH2_US of the second channel pattern.

A thickness t1 of the first gate capping pattern 145 may be different from the thickness t2 of the second gate capping pattern 245 and a thickness t3 of the third gate capping pattern 345. The thickness t2 of the second gate capping pattern 245 may be different from the thickness t3 of the third gate capping pattern 345.

For example, the thickness t3 of the third gate capping pattern 345 may be larger than the thickness t1 of the first gate capping pattern 145 and the thickness t2 of the second gate capping pattern 245. The thickness t2 of the second gate capping pattern 245 may be larger than the thickness t1 of the first gate capping pattern 145. The thickness t1 of the first gate capping pattern 145 at a portion in which the first gate capping pattern 145 overlaps the first channel pattern CH1 in the third direction D3 may be smaller than or less than the thickness t2 of the second gate capping pattern 245 at a portion in which the second gate capping pattern 245 overlaps the second channel pattern CH2 in the third direction D3. The thickness t2 of the second gate capping pattern 245 at a portion in which the second gate capping pattern 245 overlaps the second channel pattern CH2 in the third direction D3 may be smaller than or less than the thickness t3 of the third gate capping pattern 345 at a portion in which the third gate capping pattern 345 overlaps the third channel pattern CH3 in the third direction D3.

Taking the first gate spacer 140 and the first gate capping pattern 145 as an example, the first gate capping pattern 145 may be disposed on the upper surface of the first gate spacer 140. Unlike the shown example, the upper surface of the first gate spacer 140 may be disposed on the same plane with the upper surface 145US of the first gate capping pattern.

The first to third gate capping patterns 145, 245, and 345 may include, for example, at least one of silicon nitride (SiN), silicon oxynitride (SiON), silicon carbonitride (SiCN), silicon oxycarbonitride (SiOCN), and/or combinations thereof.

A gate separation structure GCS may be disposed on the substrate 100. The gate separation structure GCS may be disposed on the field insulating film 105.

The gate separation structure GCS may be in contact with the field insulating film 105. The gate separation structure GCS may protrude from the upper surface of the field insulating film 105 in the third direction D3. For example, a part of the gate separation structure GCS may enter into the field insulating film 105.

The first gate structure GS1 may be disposed between the gate separation structures GCS adjacent in the second direction D2. The second gate structure GS2 may be disposed between the gate separation structures GCS adjacent in the second direction D2. The third gate structure GS3 may be disposed between the gate separation structures GCS adjacent in the second direction D2.

Each of the first to third gate insulating films 130, 230, and 330 may not extend in the third direction D3 along the side walls of the gate separation structure GCS. Taking the first gate insulating film 130 as an example, the first gate insulating film 130 may not extend from the upper surface of the field insulating film 105 to the lower surface 145BS of the first gate capping pattern. The first gate insulating film 130 may not be in contact with the first gate capping pattern 145. Each of the first to third gate electrodes 120, 220, and 320 may be in contact with a side wall of the gate separation structure GCS.

The upper surface of the gate separation structure GCS may be disposed on the same plane with the upper surface 145US of the first gate capping pattern, the upper surface 245US of the second gate capping pattern, and/or the upper surface 345US of the third gate capping pattern.

The gate separation structure GCS includes an insulating material. The gate separation structures GCS may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), aluminum oxide (AlO), and/or combinations thereof. Although the gate separation structure GCS is shown as a single film, this is only for convenience of explanation, and the embodiment is not limited thereto.

Although the gate separation structure GCS is shown to separate also the first to third gate spacers 140, 240, and 340, this is only for convenience of explanation, and the embodiment is not limited thereto.

Although all the first to third gate structures GS1, GS2, and GS3 separated by the gate separation structure GCS are shown to intersect a single lower pattern, this is only for convenience of explanation, and the embodiment is not limited thereto. Unlike the shown example, at least one of the first to third gate structures GS1, GS2, and GS3 separated by the gate separation structure GCS may intersect a plurality of lower patterns.

The first source/drain pattern 150, the second source/drain pattern 250, the third source/drain pattern 350, and the fourth source/drain pattern 450 may be disposed on the first lower pattern BP1. The first source/drain pattern 150, the second source/drain pattern 250, the third source/drain pattern 350, and the fourth source/drain pattern 450 are in contact with the first lower pattern BP1.

The first source/drain pattern 150 may be disposed between the first gate structures GS1 adjacent in the first direction D1. The first source/drain pattern 150 may be connected to first channel patterns CH1 disposed on both sides. The first source/drain patterns 150 may be in contact with the respective first sheet patterns NS1.

The second source/drain pattern 250 may be disposed between the second gate structures GS2 adjacent in the first direction D1. The second source/drain pattern 250 may be connected to the second channel patterns CH2 disposed on both sides. The second source/drain patterns 250 may be in contact with the respective second sheet patterns NS2.

The third source/drain pattern 350 may be disposed between the third gate structures GS3 adjacent in the first direction D1. The third source/drain pattern 350 may be connected to the third channel patterns CH3 disposed on both sides. The third source/drain patterns 350 may be in contact with each third sheet pattern NS3.

The fourth source/drain pattern 450 may be disposed between the first gate structure GS1 and the second gate structure GS2 adjacent to each other in the first direction D 1. The fourth source/drain pattern 450 may be connected to the first channel pattern CH1 and the second channel pattern CH2. The fourth source/drain pattern 450 may be in contact with each first sheet pattern NS1 and each second sheet pattern NS2. In some embodiments, the fourth source/drain pattern 450 may be disposed between the second gate structure GS2 and the third gate structure GS3 adjacent to each other in the first direction D1. The fourth source/drain pattern 450 may be connected to the second channel pattern CH2 and the third channel pattern CH3. The fourth source/drain pattern 450 may be in contact with each second sheet pattern NS2 and each third sheet pattern NS3. Although not shown, the fourth source/drain pattern 450 may be disposed between the first gate structure GS1 and the third gate structure GS3 adjacent to each other in the first direction D1.

For example, the number of second sheet patterns NS2 disposed on one side of the fourth source/drain pattern 450 is larger than the number of third sheet patterns NS3 disposed on the other side of the fourth source/drain pattern 450. Therefore, from viewpoint of a cross-sectional view as in FIG. 2, the uppermost part on one side of the fourth source/drain pattern 450 may be higher than the uppermost part on the other side of the fourth source/drain pattern 450. That is, the upper surface of the fourth source/drain pattern 450 may have an inclined surface. When the fourth contact silicide film 455 is disposed on the fourth source/drain pattern 450, the upper surface of the fourth source/drain pattern 450 having an inclined surface may be inferred through the upper surface of the fourth contact silicide film 455. The upper surface of the fourth contact silicide film 455 may be in contact with a fourth source/drain contact 470.

The first inner gate structure GS1_I may be in contact with the first source/drain pattern 150. The first inner gate structure GS1_I may be in contact with the fourth source/drain pattern 450. The first gate insulating film 130 of the first inner gate structure GS1_I may be in contact with the first source/drain pattern 150 and/or the fourth source/drain pattern 450.

The first outer gate structure GS1_O may not be in contact with the first source/drain pattern 150. The first outer gate structure GS1_O may not be in contact with the fourth source/drain pattern 450.

The second inner gate structure GS2_I and the second outer gate structure GS2_O may be in contact with the second source/drain pattern 250. The second inner gate structure GS2_I and the second outer gate structure GS2_O may be in contact with the fourth source/drain pattern 450. The second gate insulating film 230 of the second inner gate structure GS2_I and the second gate insulating film 230 of the second outer gate structure GS2_O may be in contact with the second source/drain pattern 250 and/or the fourth source/drain pattern 450.

The third inner gate structure GS3_I and the third outer gate structure GS3_O may be in contact with the third source/drain pattern 350. The third inner gate structure GS3_I and the third outer gate structure GS3_O may be in contact with the fourth source/drain pattern 450. The third gate insulating film 330 of the third inner gate structure GS3_I and the third gate insulating film 330 of the third outer gate structure GS3_O may be in contact with the third source/drain pattern 350 and/or the fourth source/drain pattern 450.

The upper surface of the second source/drain pattern 250 is lower than the upper surface of the first source/drain pattern 150, and higher than the upper surface of the third source/drain pattern 350.

Each of the first to fourth source/drain patterns 150, 250, 350, and 450 may include an epitaxial pattern. Each of the first to fourth source/drain patterns 150, 250, 350, and 450 may include a semiconductor material.

The first to fourth source/drain patterns 150, 250, 350, and 450 may include dopants of the same conductivity type. The first to fourth source/drain patterns 150, 250, 350, and 450 may include p-type dopants or n-type dopants. The p-type dopants may include, but not limited to, at least one of boron (B) and/or gallium (Ga). The n-type dopants may include, but not limited to, at least one of phosphorus (P), arsenic (As), antimony (Sb), and/or bismuth (Bi).

A source/drain etching stop film 185 may extend along the outer walls of the first to third gate spacers 140, 240, and 340 and the side walls of the first to third source/drain patterns 150, 250, and 350. Although not shown, the source/drain etching stop film 185 may extend along the side walls of the fourth source/drain pattern 450.

The source/drain etching stop film 185 may extend along the upper surface of the field insulating film 105. For example, the source/drain etching stop film 185 may be in contact with the side walls of the first to third source/drain patterns 150, 250, and 350. Although not shown, the source/drain etching stop film 185 may be in contact with the side walls of the fourth source/drain pattern 450.

The source/drain etching stop film 185 may not extend along the side walls of the first gate capping pattern 145, the side walls of the second gate capping pattern 245, and the side walls of the third gate capping pattern 345. Unlike the shown example, the source/drain etching stop film 185 may extend along side walls of the first to third gate capping patterns 145, 245, and 345.

The source/drain etch stop film 185 may include, for example, at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), and/or combinations thereof.

The first upper interlayer insulating film 190 may be disposed on the substrate 100. The first upper interlayer insulating film 190 may be disposed on the source/drain etching stop film 185.

The first upper interlayer insulating film 190 may include, for example, at least one of silicon oxide, silicon nitride, silicon oxynitride, and/or a low dielectric constant material. The dielectric constant of the low dielectric constant material may have a value smaller than or less than 3.9, which is the dielectric constant of silicon oxide.

A contact separation structure CSS may be disposed inside the first upper interlayer insulating film 190. The contact separation structure CSS may not extend up to the field insulating film 105.

The contact separation structure CSS may not separation the source/drain etching stop film 185. A part of the first upper interlayer insulating film 190 may be disposed between the contact separation structure CSS and the field insulating film 105. The width of the contact separation structure CSS in the second direction D2 may increase in a direction away from the field insulating film 105.

The contact separation structure CSS may be disposed on both sides of the first to fourth source/drain patterns 150, 250, 350, and 450. In other words, the first to fourth source/drain patterns 150, 250, 350, and 450 may each be disposed between the contact separation structures CSS adjacent in the second direction D2.

The contact separation structure CSS includes an insulating material. The contact separation structure CSS may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), aluminum oxide (AlO), and/or combinations thereof. Although the contact separation structure CSS is shown as being a single film, this is only for convenience for explanation, and the embodiment is not limited thereto.

The first source/drain contact 170 may be disposed on the first source/drain pattern 150. The first source/drain contact 170 is electrically connected to the first source/drain pattern 150. The first source/drain contact 170 may be disposed on the first upper interlayer insulating film 190.

The second source/drain contact 270 may be disposed on the second source/drain pattern 250. The second source/drain contact 270 is electrically connected to the second source/drain pattern 250. The second source/drain contact 270 may be disposed on the first upper interlayer insulating film 190.

The third source/drain contact 370 may be disposed on the third source/drain pattern 350. The third source/drain contact 370 is electrically connected to the third source/drain pattern 350. The third source/drain contact 370 may be disposed on the first upper interlayer insulating film 190. The fourth source/drain contact 470 may be disposed on the fourth source/drain pattern 450. The fourth source/drain contact 470 is electrically connected to the fourth source/drain pattern 150.

The first to third source/drain contacts 170, 270, 370, and 470 are disposed between the contact separation structures CSS. The first to third source/drain contacts 170, 270, and 370 may be in contact with the contact separation structure CSS. Although not shown, the fourth source/drain contact 470 may be in contact with the contact separation structure CSS.

The height from the upper surface of the field insulating film 105 to the lower surface of the first source/drain pattern 150 may be the same as the height from the upper surface of the field insulating film 105 to the lower surface of the second source/drain pattern 250. The height from the upper surface of the field insulating film 105 to the lower surface of the first source/drain pattern 150 may be the same as the height from the upper surface of the field insulating film 105 to the lower surface of the third source/drain pattern 350.

In the cross-sectional view as in FIG. 2, the lower surface of the fourth source/drain contact 470 connected to the upper surface of the fourth source/drain pattern 450 having an inclined surface may have an inclined surface.

The first contact silicide film 155 may be disposed between the first source/drain contact 170 and the first source/drain pattern 150. The second contact silicide film 255 may be disposed between the second source/drain contact 270 and the second source/drain pattern 250. The third contact silicide film 355 may be disposed between the third source/drain contact 370 and the third source/drain pattern 350. The fourth contact silicide film 455 may be disposed between the fourth source/drain contact 470 and the fourth source/drain pattern 450.

Although the first to fourth source/drain contacts 170, 270, 370, and 470 are shown as having a single conductive film structure, the embodiment is not limited thereto. Unlike the shown example, the first to fourth source/drain contacts 170, 270, 370, and 470 may have a multi-conductive film structure including a barrier film and a plug film. The first to fourth source/drain contacts 170, 270, 370, and 470 may include, for example, at least one of metal, conductive metal nitride, conductive metal carbide, conductive metal oxide, conductive metal carbonitride, and/or a two-dimensional material (2D material). The first to fourth contact silicide films 155, 255, 355, and 455 may include a metal silicide material.

The 2D material may include a 2D allotrope or a 2D compound, and may include, but is not limited to, at least one of graphene, boron nitride (BN), molybdenum sulfide, molybdenum selenide, tungsten sulfide, tungsten selenide, and/or tantalum sulfide. That is, since the above-mentioned 2D materials are merely listed as examples, the 2D materials that may be included in the semiconductor device of the present disclosure are not limited to the above-mentioned materials.

A second upper interlayer insulating film 191 may be disposed on the first to third gate capping patterns 145, 245, and 345 and the first to fourth source/drain contacts 170, 270, 370, and 470.

The second upper interlayer insulating film 191 may include, for example, at least one of silicon oxide, silicon nitride, silicon oxynitride, and/or a low dielectric constant material. The dielectric constant of the low dielectric constant material may have a value smaller than or less than 3.9, which is the dielectric constant of silicon oxide.

A first gate contact 175 may be disposed inside the second upper interlayer insulating film 191 and the first gate capping pattern 145. The first gate contact 175 may pass through the second upper interlayer insulating film 191 and the first gate capping pattern 145. The first gate contact 175 may be connected to the first gate electrode 120.

A second gate contact 275 may be disposed inside the second upper interlayer insulating film 191 and the second gate capping pattern 245. The second gate contact 275 may pass through the second upper interlayer insulating film 191 and the second gate capping pattern 245. The second gate contact 275 may be connected to the second gate electrode 220.

A third gate contact 375 may be disposed inside the second upper interlayer insulating film 191 and the third gate capping pattern 345. The third gate contact 375 may pass through the second upper interlayer insulating film 191 and the third gate capping pattern 345. The third gate contact 375 may be connected to the third gate electrode 320.

A height H14 from the upper surface BP1_US of the first lower pattern to the lower surface of the first gate contact 175 may be the same as a height H24 from the upper surface BP1_US of the first lower pattern to the lower surface of the second gate contact 275. The height H14 from the upper surface BP1_US of the first lower pattern to the lower surface of the first gate contact 175 may be the same as a height H34 from the upper surface BP1_US of the first lower pattern to the lower surface of the third gate contact 375.

For example, the second gate contact 275 may be connected to the second portion 220R2 of the second gate electrode. The second gate contact 275 may be in contact with the upper surface 220US of the second portion 220R2 of the second gate electrode. The third gate contact 375 may be connected to the second portion 320R2 of the third gate electrode. The third gate contact 375 may be in contact with the upper surface 320US of the second portion 320R2 of the third gate electrode.

Although the first gate contact 175 is shown as being connected to the second portion 120R2 of the first gate electrode, the embodiment is not limited thereto. It goes without saying that the first gate contact 175 may be connected to the first portion 120R1 of the first gate electrode.

Although the first to third gate contacts 175, 275, and 375 are shown as having a single conductive film structure, the embodiment is not limited thereto. Unlike the shown example, the first to third gate contacts 175, 275, and 375 may have a multi-conductive film structure including a barrier film and a plug film. The first to third gate contacts 175, 275, and 375 may include, for example, at least one of a metal, conductive metal nitride, conductive metal carbide, conductive metal oxide, conductive metal carbonitride, and/or a two-dimensional material.

The source/drain via 195 may be disposed inside the second upper interlayer insulating film 191. The source/drain via 195 may be disposed on the first to third source/drain contacts 170, 270, and 370. The source/drain via 195 may be connected to the first to third source/drain contacts 170, 270, and 370. Although not shown, the source/drain via 195 may be connected to the fourth source/drain contact 470.

Although the source/drain via 195 is shown as having a single conductive film structure, the embodiment is not limited thereto. Unlike the shown example, the source/drain via 195 may have a multi-conductive film structure including a barrier film and a plug film. The source/drain via 195 may include, for example, at least one of a metal, conductive metal nitride, conductive metal carbide, conductive metal oxide, conductive metal carbonitride, and/or a two-dimensional material.

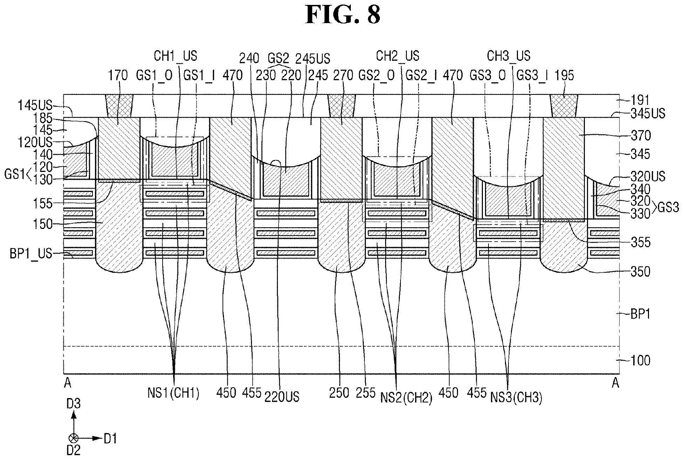

FIGS. 8 to 11 are diagrams for explaining a semiconductor device according to some embodiments, respectively. For convenience of explanation, points different from those described using FIGS. 1 to 7 will be mainly explained.

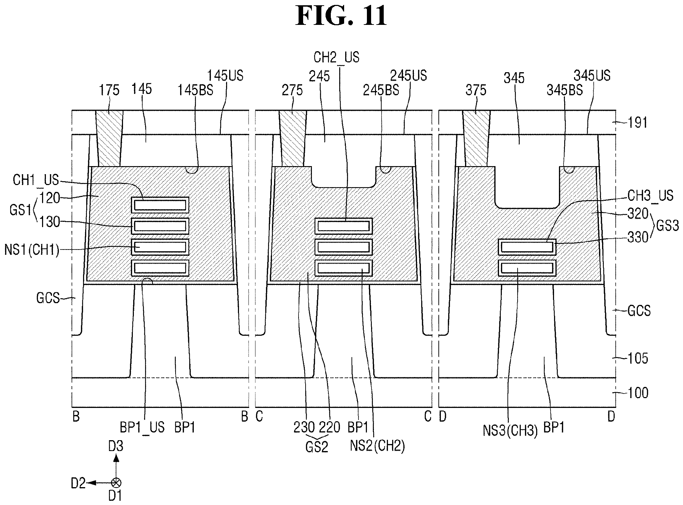

For reference, FIGS. 8 to 10 are cross-sectional views taken along line A-A of FIG. 1, respectively. FIG. 11 is a cross-sectional view taken along lines B-B, C-C, and D-D of FIG. 1.

Referring to FIG. 8, in the semiconductor device according to some embodiments, the second outer gate structure GS2_O may not be in contact with the second source/drain pattern 250 and/or the fourth source/drain pattern 450.

The third outer gate structure GS3_O may not be in contact with the third source/drain pattern 350 and/or the fourth source/drain pattern 450.

From viewpoint of a cross-sectional view, the second gate spacer 240 does not rest on the second outer gate structure GS2_O. The second outer gate structure GS2_O does not enter between the second gate spacer 240 and the second channel pattern CH2.

The third gate spacer 340 does not rest on the third outer gate structure GS3_O. A part of the third outer gate structure GS3_O does not enter between the third gate spacer 340 and the third channel pattern CH3.

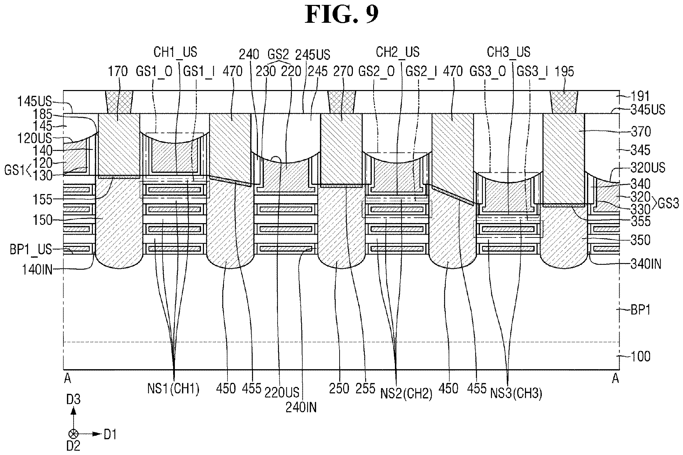

Referring to FIG. 9, the semiconductor device according to some embodiments may further include a first inner spacer 140IN, a second inner spacer 240IN, and a third inner spacer 340IN.

The first inner spacer 140IN may be disposed between the first inner gate structure GS1_I and the first source/drain pattern 150. The first inner spacer 140IN may be disposed between the first inner gate structure GS1_I and the fourth source/drain pattern 450. From viewpoint of a cross-sectional view, the first inner spacer 140IN is not disposed on the upper surface CH1_US of the first channel pattern. The first inner spacer 140IN may be in contact with the first inner gate structure GS1_I, the first source/drain pattern 150, and the fourth source/drain pattern 450.

The second inner spacer 240IN may be disposed between the second inner gate structure GS2_I and the second source/drain pattern 250. The second inner spacer 240IN may be disposed between the second inner gate structure GS2_I and the fourth source/drain pattern 450. The second inner spacer 240IN may be in contact with the second inner gate structure GS2_I, the second source/drain pattern 250, and the fourth source/drain pattern 450.

The second inner spacer 240IN may be disposed between the second outer gate structure GS2_O and the second source/drain pattern 250. The second inner spacer 240IN may be disposed between the second outer gate structure GS2_O and the fourth source/drain pattern 450. From viewpoint of a cross-sectional view, the second inner spacer 240IN may be disposed on the upper surface CH2_US of the second channel pattern.

The third inner spacer 340IN may be disposed between the third inner gate structure GS3_I and the third source/drain pattern 350. The third inner spacer 340IN may be disposed between the third inner gate structure GS3_I and the fourth source/drain pattern 450. The third inner spacer 340IN may be in contact with the third inner gate structure GS_I, the third source/drain pattern 350, and the fourth source/drain pattern 450.

The third inner spacer 340IN may be disposed between the third outer gate structure GS3_O and the third source/drain pattern 350. The third inner spacer 340IN may be disposed between the third outer gate structure GS3_O and the fourth source/drain pattern 450. From viewpoint of a cross-sectional view, the third inner spacer 340IN may be disposed on the upper surface CH2_US of the second channel pattern.

The first inner spacer 140IN, the second inner spacer 240IN, and the third inner spacer 340IN may each include an insulating material.

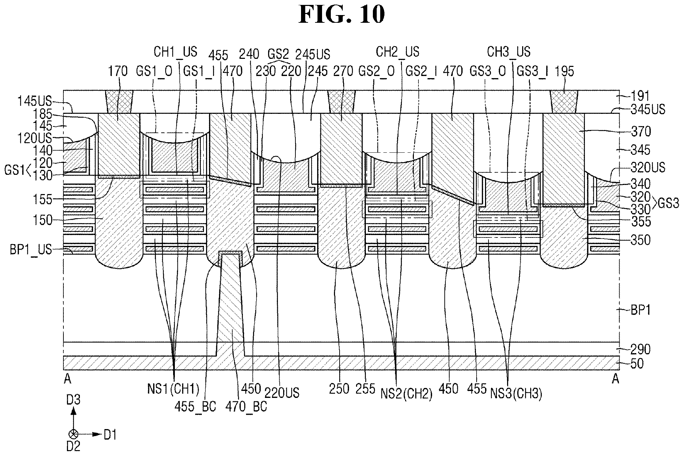

Referring to FIG. 10, the semiconductor device according to some embodiments may further include a back source/drain contact 470_BC and a back wiring line 50.

The first lower pattern BP1 may be disposed on an insulating substrate 290. The insulating substrate 290 may be disposed on the lower surface of the first lower pattern BP1. The lower surface of the first lower pattern BP1 may be opposite to the upper surface BP1_US of the first lower pattern in the third direction D3.

The insulating substrate 290 includes an insulating material, and may include at least one of silicon oxide, silicon nitride, and/or combinations thereof. The insulating substrate 290 may be a substrate formed by a vapor deposition process or the like after the substrate 100 of FIGS. 2 to 4 is removed during the manufacturing process.

The back wiring line 50 may be disposed inside the insulating substrate 290. The back wiring line 50 may include a line portion and a via portion. Although the line portion of the back wiring line 50 is shown to extend in the first direction D1, this is only for convenience of explanation, and the embodiment is not limited thereto. The via portion of the back wiring line 50 may protrude from the line portion of the back wiring line 50 in the third direction D3. Unlike the shown example, the back wiring line 50 may not include a via portion.

The back source/drain contact 470_BC may be disposed between the fourth source/drain pattern 450 and the back wiring line 50. The back source/drain contact 470_BC electrically connects the fourth source/drain contact 470 and the back wiring line 50.

Although the back source/drain contact 470_BC is shown as being connected to a part of the fourth source/drain pattern 450, this is only for convenience of explanation, and the embodiment is not limited thereto.

Although the back wiring line 50 is shown as being connected to the fourth source/drain pattern 450, the embodiment is not limited thereto. The back wiring line 50 may be connected to at least one of the first to third source/drain patterns 150, 250, and 350.

A back contact silicide film 455_BC may be disposed between the back source/drain contact 470_BC and the fourth source/drain pattern 450. The back contact silicide film 455_BC may include a metal silicide material.

Although the back source/drain contact 470_BC and the back wiring line 50 are each shown as being a single conductive film, the embodiment is not limited thereto. Unlike the shown example, at least one of the back source/drain contact 470_BC and the back wiring line 50 may have a multi-conductive film structure including a barrier film and a release film. The back contact silicide film 455_BC and the back wiring line 50 may each include, for example, at least one of a metal, conductive metal nitride, conductive metal carbide, conductive metal oxide, conductive metal carbonitride, and/or a two-dimensional material.

Referring to FIG. 11, in the semiconductor device according to some embodiments, the first to third gate insulating films 130, 230, and 330 may each extend in the third direction D3 along the side wall of the gate separation structure GCS.

Taking the first gate insulating film 130 as an example, the first gate insulating film 130 may extend from the upper surface of the field insulating film 105 to the lower surface 145BS of the first gate capping pattern. The first gate insulating film 130 may be in contact with the first gate capping pattern 145. From viewpoint of a cross-sectional view, each of the first to third gate electrodes 120, 220, and 320 may not be in contact with the side wall of the gate separation structure GCS.

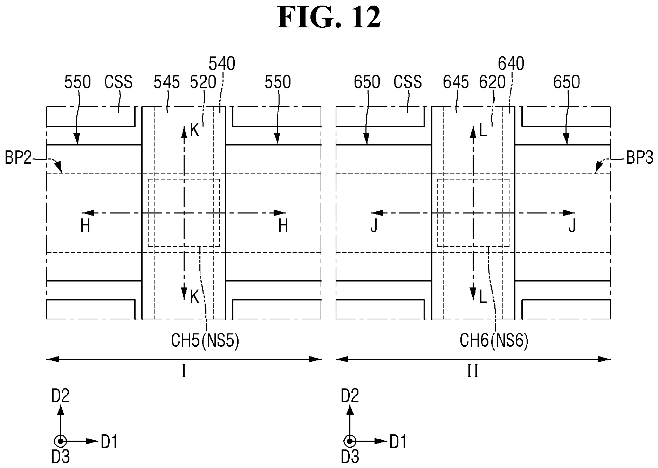

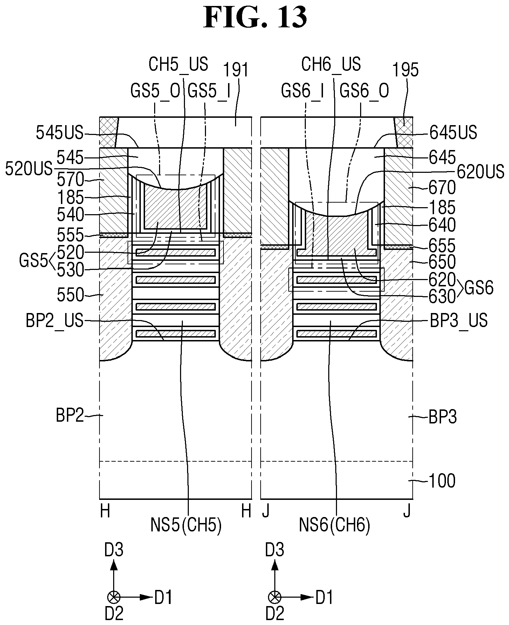

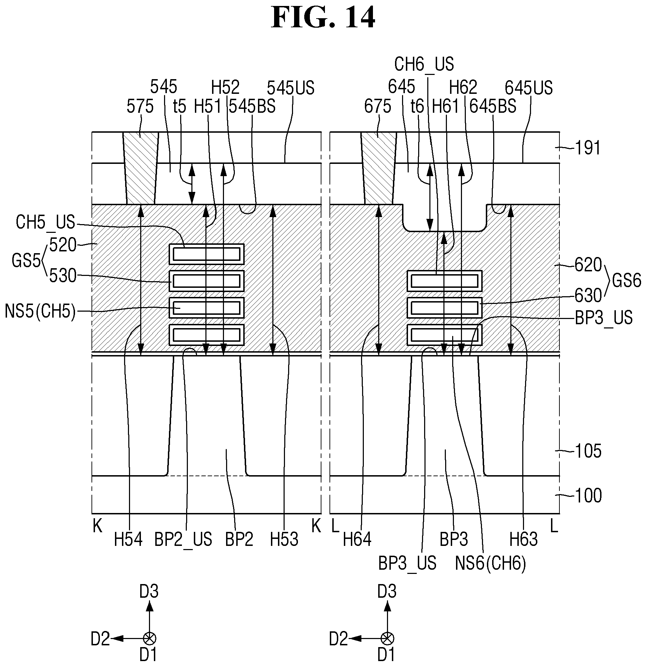

FIGS. 12 to 14 are diagrams for explaining a semiconductor device according to some embodiments. For reference, FIG. 12 is an example plan view for explaining a semiconductor device according to some embodiments. FIG. 13 is a cross-sectional view taken along lines H-H and J-J of FIG. 12. FIG. 14 is a cross-sectional view taken along lines K-K and L-L of FIG. 12.

Since the explanation of a lower pattern, a channel pattern, a gate structure, a gate capping pattern, a gate contact, and the like to be described below may be the same as that explained using FIGS. 1 to 11, the explanation thereof will be simplified or omitted.

Referring to FIGS. 12 to 14, the semiconductor device according to some embodiments may include a second lower pattern BP2, a third lower pattern BP3, a fifth channel pattern CH5, a sixth channel pattern CH6, a fifth gate structure GS5, a sixth gate structure GS6, a fifth gate capping pattern 545, a sixth gate capping pattern 645, a fifth source/drain pattern 550, a sixth source/drain pattern 650, a fifth gate contact 575, and a sixth gate contact 675.

The substrate 100 may include a first region I and a second region II. The first region I and the second region II may each be one of a logic region, an SRAM region, and an I/O region. As an example, the first region I and the second region II may be regions that perform the same function. As another example, the first region I and the second region II may be regions that perform different functions from each other.

As an example, the first region I and the second region II may be regions in which transistors of the same conductivity type are formed. As another example, the first region I and the second region II may be regions in which transistors of different conductivity types are formed.

The second lower pattern BP2 and the third lower pattern BP3 may each protrude from the substrate 100 in the third direction D3. The second lower pattern BP2 and the third lower pattern BP3 may each extend in the first direction D1.

The field insulating film 105 may cover or overlap at least a part of the side wall of the second lower pattern BP2. The field insulating film 105 may cover or overlap at least a part of the side wall of the third lower pattern BP3.

The fifth channel pattern CH5 may be disposed on the second lower pattern BP2. The fifth channel pattern CH5 may be disposed on the upper surface BP2_US of the second lower pattern. The sixth channel pattern CH6 may be disposed on the third lower pattern BP3. The sixth channel pattern CH6 may be disposed on the upper surface BP3_US of the third lower pattern.

The fifth channel pattern CH5 may include a plurality of fifth sheet patterns NS5. Each of the fifth sheet patterns NS5 may be disposed on the upper surface BP2_US of the second lower pattern to be spaced apart from each other in the third direction D3. The sixth channel pattern CH6 may include a plurality of sixth sheet patterns NS6. Each of the sixth sheet patterns NS6 may be disposed on the upper surface BP3_US of the third lower pattern to be spaced apart from each other in the third direction D3.

In the semiconductor device according to some embodiments, the number of fifth sheet patterns NS5 may be different from the number of sixth sheet patterns NS6. For example, the number of fifth sheet patterns NS5 included in the fifth channel pattern CH5 may be larger than the number of sixth sheet patterns NS6 included in the sixth channel pattern CH6.

The upper surface CH5_US of the fifth channel pattern may be the upper surface of the fifth sheet pattern NS5 disposed at the uppermost part of the fifth sheet pattern NS5 included in the fifth channel pattern CH5. The upper surface CH6_US of the sixth channel pattern may be the upper surface of the sixth sheet pattern NS6 disposed at the uppermost part of the sixth sheet pattern NS6 included in the sixth channel pattern CH6. A height from the upper surface BP2_US of the second lower pattern to the upper surface CH5_US of the fifth channel pattern is larger than the height from the upper surface BP3_US of the third lower pattern to the upper surface CH6_US of the sixth channel pattern.

The fifth gate structure GS5 may be disposed on the second lower pattern BP2. The fifth gate structure GS5 may intersect the second lower pattern BP2. The sixth gate structure GS6 may be disposed on the third lower pattern BP3. The sixth gate structure GS6 may intersect the third lower pattern BP3.

The fifth gate structure GS5 may surround the fifth channel pattern CH5. The fifth gate structure GS5 may surround each fifth sheet pattern NS5. The fifth gate structure GS5 may include a fifth inner gate structure GS5_I and a fifth outer gate structure GS5_O. The fifth gate structure GS5 may include a fifth gate electrode 520 and a fifth gate insulating film 530.

The sixth gate structure GS6 may surround the sixth channel pattern CH6. The sixth gate structure GS6 may surround each sixth sheet pattern NS6. The sixth gate structure GS6 may include a sixth inner gate structure GS6_I and a sixth outer gate structure GS6_O. The sixth gate structure GS6 may include a sixth gate electrode 620 and a sixth gate insulating film 630.

The fifth gate electrode 520 may include a first portion and a second portion. The second portion of the fifth gate electrode 520 may be located on both sides of the first portion of the fifth gate electrode 520. In a cross-sectional view as in FIG. 14, the upper surface 520US of the fifth gate electrode may be flat. The first portion of the fifth gate electrode 520 may overlap the fifth channel pattern CH5 in the third direction D3. The second portion of the fifth gate electrode 520 may not overlap the fifth channel pattern CH5 in the third direction D3.

The sixth gate electrode 620 may include a first portion and a second portion. The second portion of the sixth gate electrode 620 may be located on both sides of the first portion of the sixth gate electrode 620. In the cross-sectional view as in FIG. 14, the upper surface 620US of the sixth gate electrode may include a region that is recessed toward the sixth channel pattern CH6. The first portion of the sixth gate electrode 620 may be a region in which a part of the sixth gate electrode 620 is recessed. The first portion of the sixth gate electrode 620 may overlap the sixth channel pattern CH6 in the third direction D3. The second portion of the sixth gate electrode 620 may not overlap the sixth channel pattern CH6 in the third direction D3.

For example, a height H51 from the upper surface BP2_US of the second lower pattern to the upper surface 520US of the first portion of the fifth gate electrode 520 is larger than a height H61 from the upper surface BP3_US of the third lower pattern to the upper surface 620US of the first portion of the sixth gate electrode 620.

A height H53 from the upper surface BP2_US of the second lower pattern to the upper surface 520US of the second portion of the fifth gate electrode 520 may be the same as a height H63 from the upper surface BP3_US of the third lower pattern to the upper surface 620US of the second portion of the sixth gate electrode 620.

Unlike the shown example, the shape of the fifth gate electrode 520 may be similar to the shape of the second gate electrode 220 of FIGS. 2 and 3, and the shape of the sixth gate electrode 620 may be similar to the shape of the third gate electrode 320 of FIGS. 2 and 3. In such a case, the explanation of the cross sections of the second gate electrode 220 and the third gate electrode 320 explained using FIG. 3 may be applied to the explanation of the cross sections of the fifth gate electrode 520 and the sixth gate electrode 620.

A fifth gate spacer 540 may be disposed on a side wall of the fifth gate structure GS5. A sixth gate spacer 640 may be disposed on a side wall of the sixth gate structure GS6.

For example, in the cross-sectional view as in FIG. 13, the fifth outer gate structure GS5_O may not enter between the fifth gate spacer 540 and the fifth channel pattern CH5. A part of the sixth outer gate structure GS6_O may enter between the sixth gate spacer 640 and the sixth channel pattern CH6.

Unlike the shown example, if the shape of the fifth gate structure GS5 is similar to the shapes of the second gate structure GS2 and the third gate structure GS3 of FIG. 2, the fifth gate spacer 540 may have a shape that rests on the fifth outer gate structure GS5_O.

The fifth gate capping pattern 545 may be disposed on the upper surface 520US of the fifth gate electrode. The lower surface 545BS of the fifth gate capping pattern may be in contact with the upper surface 520US of the fifth gate electrode.

The sixth gate capping pattern 645 may be disposed on the upper surface 620US of the sixth gate electrode. The lower surface 645BS of the sixth gate capping pattern may be in contact with the upper surface 620US of the sixth gate electrode.

The upper surface 545US of the fifth gate capping pattern may be disposed on the same plane with the upper surface 645US of the sixth gate capping pattern. A height H52 from the upper surface BP2_US of the second lower pattern to the upper surface 545US of the fifth gate capping pattern may be the same as a height H62 from the upper surface BP3_US of the third lower pattern to the upper surface 645US of the sixth gate capping pattern.

A thickness t5 of the fifth gate capping pattern 545 may be different from a thickness t6 of the sixth gate capping pattern 645. The thickness t5 of the fifth gate capping pattern 545 may be smaller than or less than the thickness t6 of the sixth gate capping pattern 645.

The fifth gate structure GS5 and/or the sixth gate structure GS6 may be disposed between the gate separation structures GCS adjacent in the second direction D2.

The fifth source/drain pattern 550 may be disposed on the second lower pattern BP2. The fifth source/drain pattern 550 may be disposed on both sides of the fifth gate structure GS5. The fifth source/drain pattern 550 may be connected to the fifth channel pattern CH5.

The sixth source/drain pattern 650 may be disposed on the third lower pattern BP3. The sixth source/drain pattern 650 may be disposed on both sides of the sixth gate structure GS6. The sixth source/drain pattern 650 may be connected to the sixth channel pattern CH6.

The fifth inner gate structure GS5_I may be in contact with the fifth source/drain pattern 550. The fifth outer gate structure GS5_O may not be in contact with the fifth source/drain pattern 550.

The sixth inner gate structure GS6_I may be in contact with the sixth source/drain pattern 650. The sixth outer gate structure GS6_O may be in contact with the sixth source/drain pattern 550.

The fifth and sixth source/drain patterns 550 and 650 may each include an epitaxial pattern. The fifth and sixth source/drain patterns 550 and 650 may each include a semiconductor material.

The fifth and sixth source/drain patterns 550 and 650 may each be disposed between the contact separation structures CSS adjacent in the second direction D2.

A fifth source/drain contact 570 may be disposed on the fifth source/drain pattern 550. The fifth source/drain contact 570 is electrically connected to the fifth source/drain pattern 550. A sixth source/drain contact 670 may be disposed on the sixth source/drain pattern 650. The sixth source/drain contact 670 is electrically connected to the sixth source/drain pattern 650.

The fifth contact silicide film 555 may be disposed between the fifth source/drain contact 570 and the fifth source/drain pattern 550. The sixth contact silicide film 655 may be disposed between the sixth source/drain contact 670 and the sixth source/drain pattern 650.

The fifth gate contact 575 may pass through the second upper interlayer insulating film 191 and the fifth gate capping pattern 545. The fifth gate contact 575 may be connected to the fifth gate electrode 520.

The sixth gate contact 675 may pass through the second upper interlayer insulating film 191 and the sixth gate capping pattern 645. The sixth gate contact 675 may be connected to the sixth gate electrode 620.

A height H54 from the upper surface BP2_US of the second lower pattern to the lower surface of the fifth gate contact 575 may be the same as a height H64 from the upper surface BP3_US of the third lower pattern to the lower surface of the sixth gate contact 675. For example, the sixth gate contact 675 may be connected to the second portion of the sixth gate electrode 620.

The source/drain via 195 may be disposed on the fifth and sixth source/drain contacts 570 and 670. The source/drain via 195 may be connected to the fifth and sixth source/drain contacts 570 and 670.

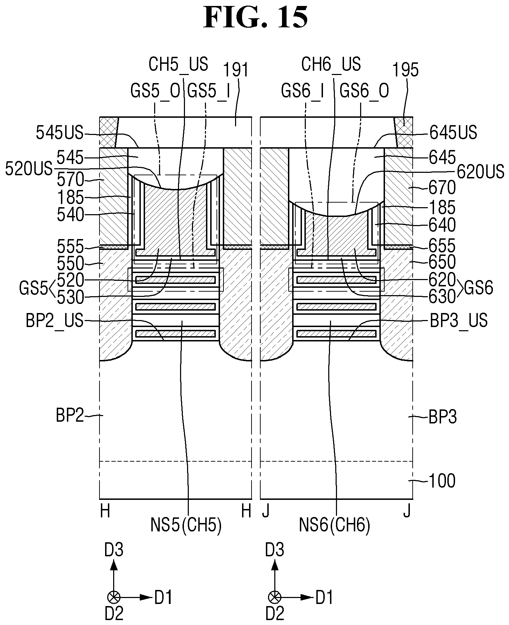

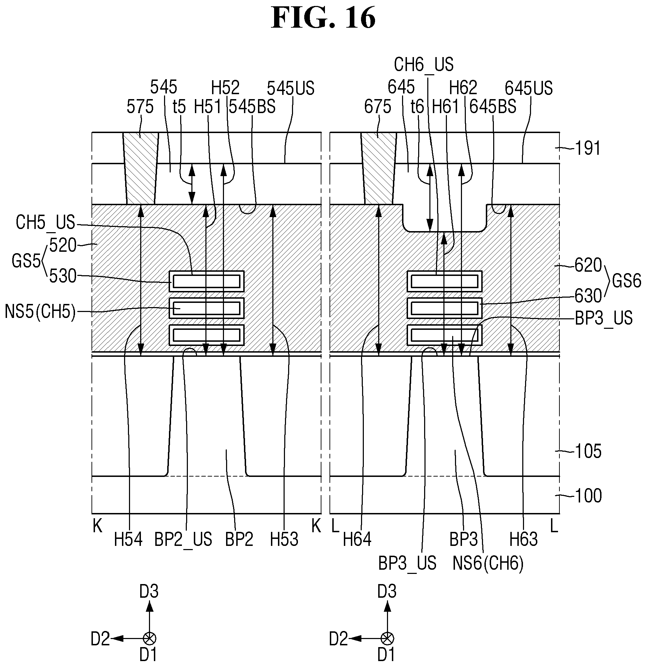

FIGS. 15 and 16 are diagrams for explaining a semiconductor device according to some embodiments. For convenience of explanation, the explanation will focus on the points that are different from those explained using FIGS. 12 to 14.

Referring to FIGS. 15 and 16, in the semiconductor device according to some embodiments, the number of fifth sheet patterns NS5 included in the fifth channel pattern CH5 may be the same as the number of the sixth sheet patterns NS6 included in the sixth channel pattern CH6.

A height from the upper surface BP2_US of the second lower pattern to the upper surface CH5_US of the fifth channel pattern may be the same as the height from the upper surface BP3_US of the third lower pattern to the upper surface CH6_US of the sixth channel pattern.

In FIG. 15, the height from the upper surface CH5_US of the fifth channel pattern to the upper surface 520US of the fifth gate electrode is larger than the height from the upper surface CH6_US of the sixth channel pattern to the upper surface 620US of the sixth gate electrode.

The fifth outer gate structure GS5_O may enter between the fifth gate spacer 540 and the fifth channel pattern CH5. The fifth gate spacer 540 may have a shape that rests on the fifth outer gate structure GS5_O.

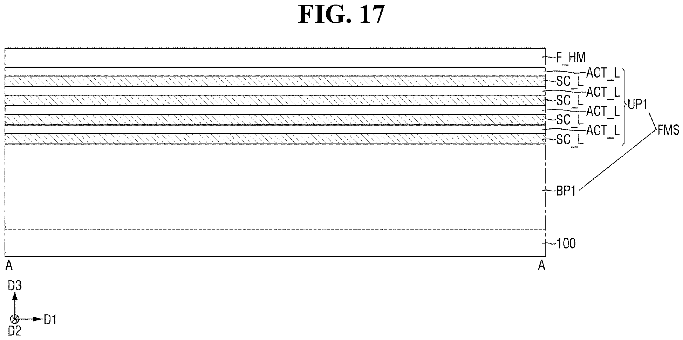

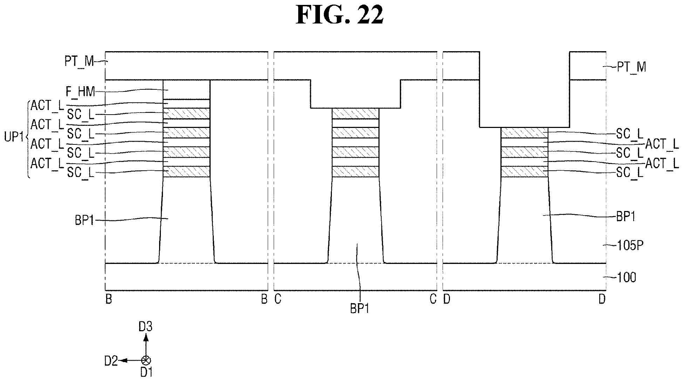

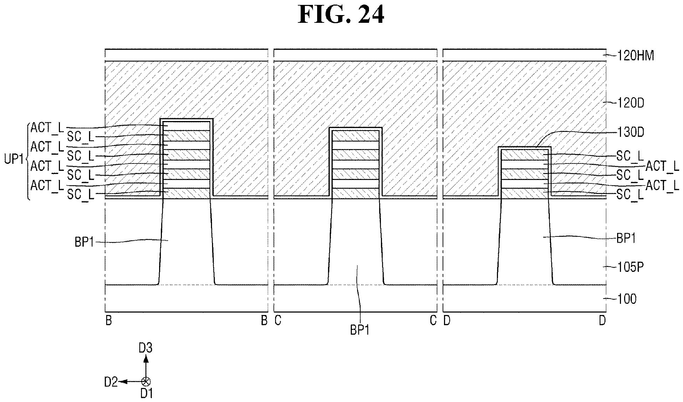

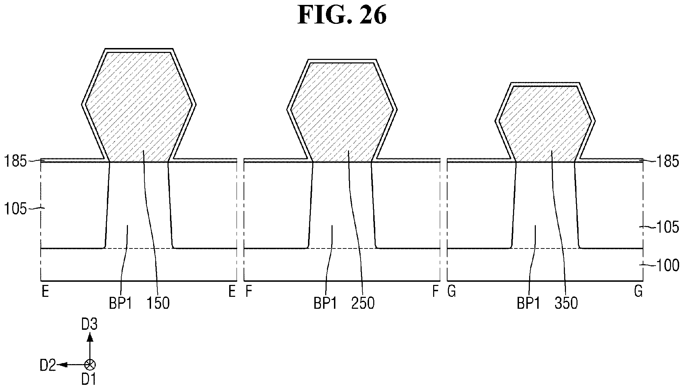

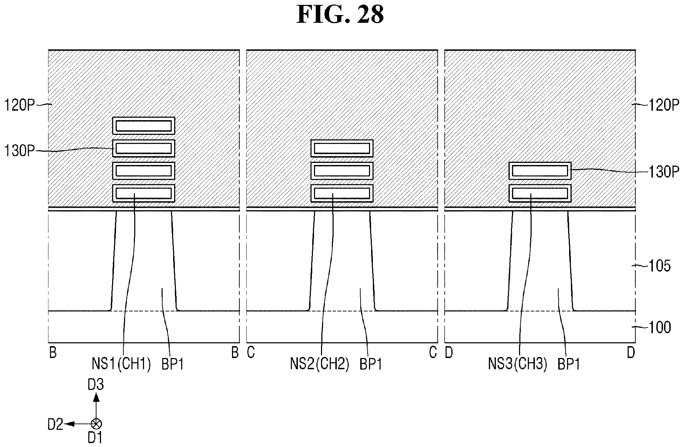

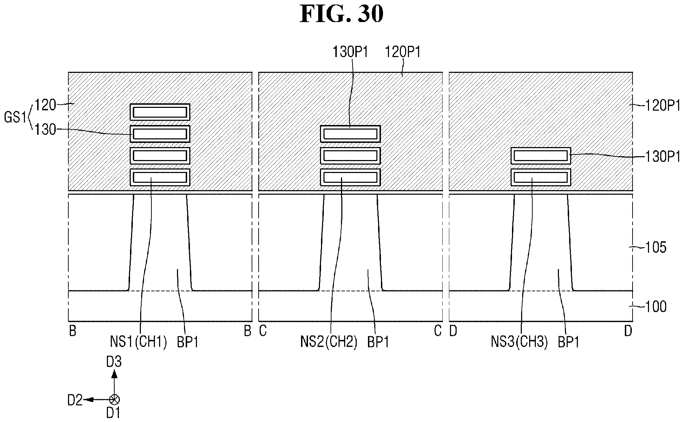

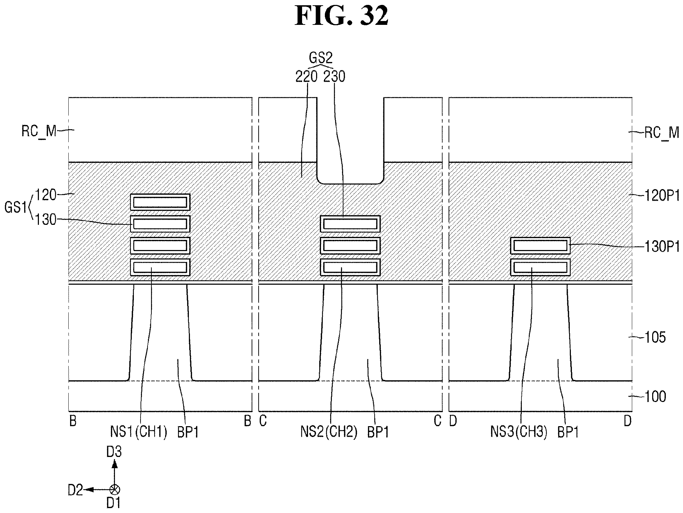

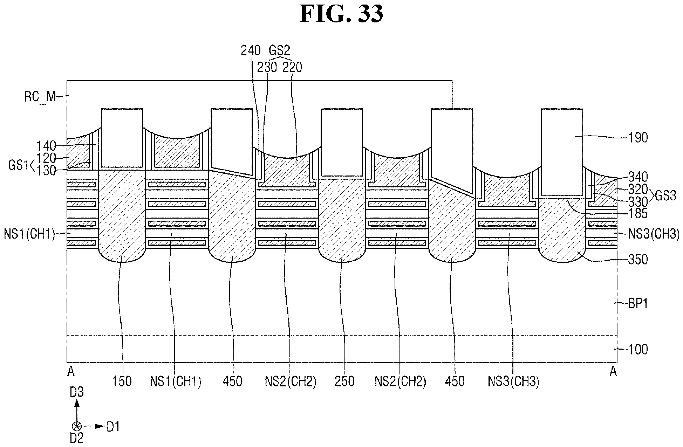

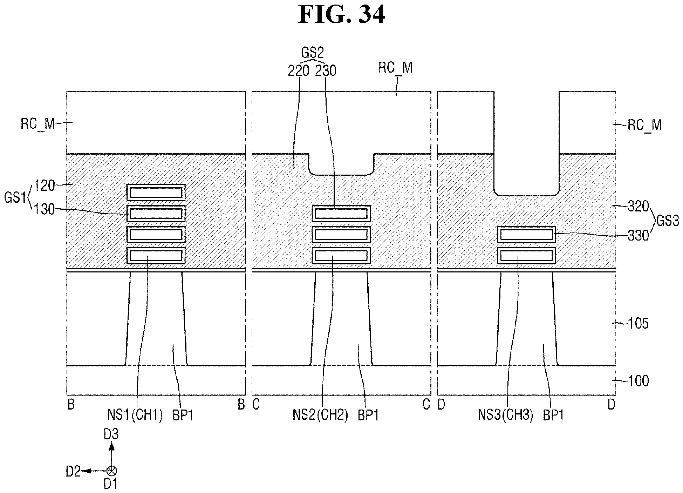

FIGS. 17 to 34 are intermediate stage diagrams for explaining a method for manufacturing a semiconductor device according to some embodiments.

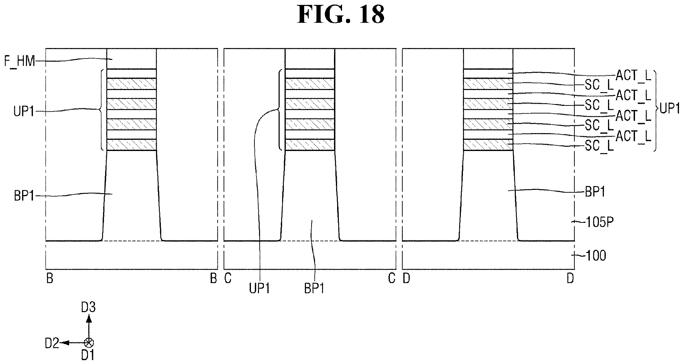

Referring to FIGS. 17 and 18, a mold fin-shaped pattern FMS may be formed on the substrate 100.

The mold fin-shaped pattern FMS may extend in the first direction D1. The mold fin-shaped pattern FMS may include a first lower pattern BP1 and an upper pattern structure UP1. The upper pattern structure UP1 may be formed on the first lower pattern BP1.

The upper pattern structure UP1 may include a plurality of sacrificial patterns SC_L and a plurality of active patterns ACT_L, which are alternately stacked. For example, the active pattern ACT_L may include a silicon film. The sacrificial pattern SC_L may include a silicon-germanium film. In the upper pattern structure UP1, the active pattern ACT_L may be disposed at the uppermost part.

A mold hard mask pattern F_HM may be disposed on the mold fin-shaped pattern FMS. The mold hard mask pattern F_HM may be used as a mask for forming the mold fin-shaped pattern FMS. For example, the mold hard mask pattern F_HM may include, but not limited to, silicon nitride.

Subsequently, a pre-field insulating film 105P may be formed on the substrate 100. The pre-field insulating film 105P may cover or overlap the side walls of the mold fin-shaped pattern FMS and the side walls of the mold hard mask pattern F_HM. The pre-field insulating film 105P may not cover or may not overlap the upper surface of the mold hard mask pattern F_HM.

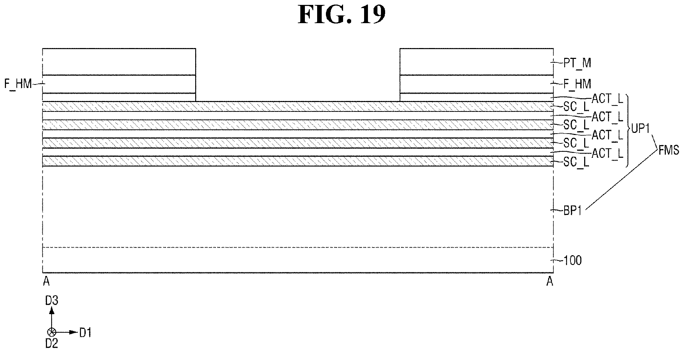

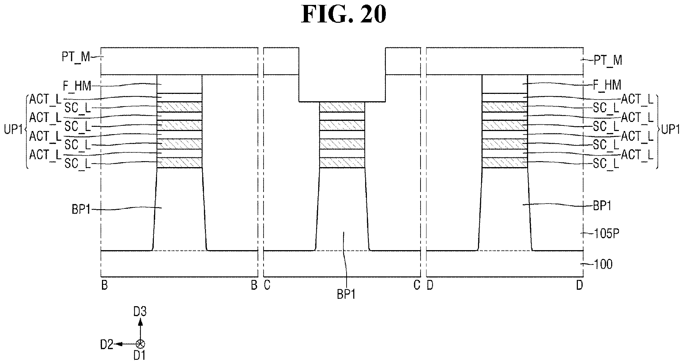

Referring to FIGS. 19 and 20, a pattern mask PT_M may be formed on the pre-field insulating film 105P and the mold hard mask pattern F_HM.

The pattern mask PT_M may include a first opening that exposes a part of the mold hard mask pattern F_HM. The first etching process may be performed, using the pattern mask PT_M including the first opening.

While the first etching process is in progress, the mold hard mask pattern F_HM of a portion that overlaps the first opening may be removed. Further, while the first etching process is in progress, at least one or more active patterns ACT_L may be removed from the portion that overlaps the first opening. For example, the first etching process may remove a part of one active pattern ACT_L. For example, the first etching process may be ended when the sacrificial pattern SC_L disposed at the uppermost part is exposed. A first etching trench may be formed through the first etching process.

Referring to FIGS. 19 to 22, the first etching trench formed during the first etching process may be filled with a pattern mask PT_M.

Next, a second opening that exposes another part of the mold hard mask pattern F_HM may be formed in the pattern mask PT_M. The second etching process may be performed, using the pattern mask PT_M including the second opening.

While the second etching process is in progress, the mold hard mask pattern F_HM of the portion that overlaps the second opening may be removed. Further, while the second etching process is in progress, at least one or more active patterns ACT_L may be removed from the portion that overlaps the second opening. For example, the second etching process may remove a part of the two active patterns ACT_L. For example, a part of the sacrificial pattern SC_L disposed at the uppermost part may also be removed during the second etching process. The second etching process may end when the sacrificial pattern SC_L located just below the uppermost part is exposed.

A plurality of steps having a stepped shape may be formed in the mold fin-shaped pattern FMS through the first etching process and the second etching process.

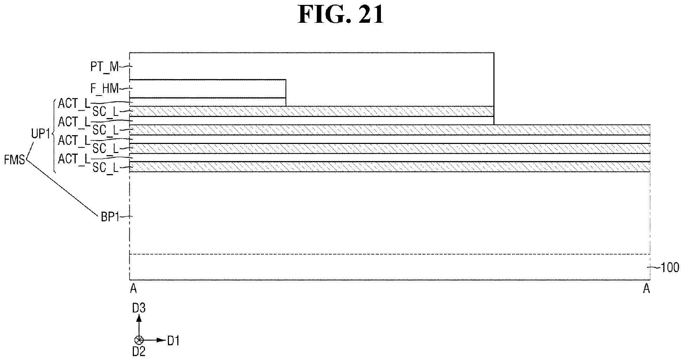

Referring to FIGS. 21 to 24, the pattern mask PT_M may be removed.

Thereafter, the mold hard mask pattern F_HM may be removed. The field insulating film 105 may be formed on the substrate 100 by removing a part of the pre-field insulating film 105P. The field insulating film 105 may cover or overlap side walls of the first lower pattern BP 1.

A plurality of dummy gate electrodes 120D may then be formed on the mold fin-shaped pattern FMS. The plurality of dummy gate electrodes 120D may not to be formed at the stepped portion of the mold fin-shaped pattern FMS. In some embodiments, the dummy gate electrode 120D does not overlap the stepped portion of the mold fin-shaped pattern FMS in the third direction D3.

Each dummy gate electrode 120D may intersect the mold fin-shaped pattern FMS. Each dummy gate electrode 120D may extend in the second direction D2. Each dummy gate electrode 120D may be spaced apart in the first direction D1.

The dummy gate insulating film 130D may be formed between the dummy gate electrode 120D and the mold fin-shaped pattern FMS. The dummy gate insulating film 130D may be formed along the profile of the mold fin-shaped pattern FMS. The dummy gate capping film 120HM may be formed on the dummy gate electrode 120D. The dummy gate electrode 120D may be formed using the dummy gate capping film 120HM as a mask.

The dummy gate electrode 120D may include, for example, but not limited thereto, polysilicon. The dummy gate insulating film 130D may include, but not limited to, silicon oxide. The dummy gate capping film 120HM may include, for example, but not limited to, silicon nitride.

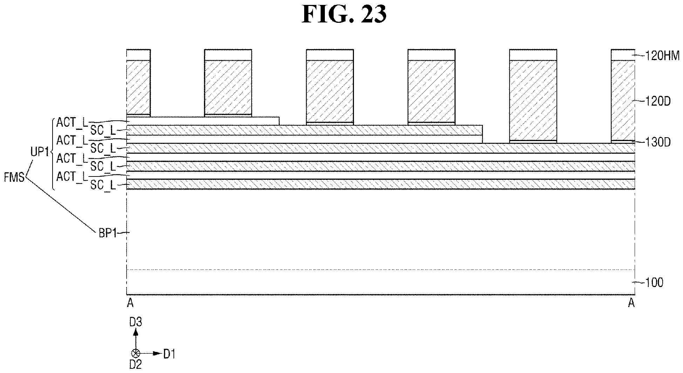

Referring to FIGS. 23 to 26, a dummy gate spacer 140D may be formed on the side walls of the dummy gate electrodes 120D.

While the dummy gate spacers 140D are being formed, a source/drain recess may be formed inside the mold fin-shaped pattern FMS. The source/drain recess may be formed between dummy gate electrodes 120D adjacent in the first direction D1.

The first to fourth source/drain patterns 150, 250, 350, and 450 may be formed inside the mold fin-shaped pattern FMS. The first to fourth source/drain patterns 150, 250, 350, and 450 may fill the source/drain recesses.

The first to fourth source/drain patterns 150, 250, 350, and 450 may be formed on the first lower pattern BP1. The first to fourth source/drain patterns 150, 250, 350, and 450 may be formed between the dummy gate electrodes 120D adjacent to each other in the first direction D1. The upper surface of the fourth source/drain pattern 450 formed at the stepped portion of the mold fin-shaped pattern FMS may have an inclined surface.

Subsequently, the source/drain etching stop film 185 may be formed on the first to fourth source/drain patterns 150, 250, 350, and 450. The source/drain etching stop film 185 may be formed along the profiles of the first to fourth source/drain patterns 150, 250, 350, and 450.

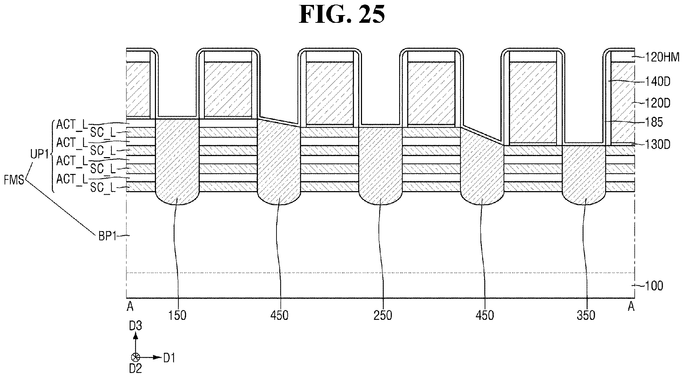

Referring to FIGS. 25 to 28, a first upper interlayer insulating film 190 may be formed on the source/drain etching stop film 185.

A part of the first upper interlayer insulating film 190 and the dummy gate capping film 120HM may be removed to expose the upper surface of the dummy gate electrode 120D. While the upper surface of the dummy gate electrode 120D is being exposed, the first pre-gate spacer 140P may be formed.

Subsequently, the dummy gate insulating film 130D and the dummy gate electrode 120D may be removed to expose the upper pattern structure UP1 between the first pre-gate spacers 140P.

Next, by removing the sacrificial pattern SC_L, a first channel pattern CH1 including the first sheet pattern NS1, a second channel pattern CH2 including the second sheet pattern NS2, and a third channel pattern CH3 including the three-sheet pattern NS3 may be formed. A gate trench is formed between the first pre-gate spacers 140P accordingly.

Subsequently, a first pre-gate insulating film 130P and a first pre-gate electrode 120P may be formed inside the gate trench. The first pre-gate insulating film 130P and the first pre-gate electrode 120P may surround the first sheet pattern NS 1, the second sheet pattern NS2, and the third sheet pattern NS3 in a cross-sectional plane of the first direction D1 and the third direction D3.

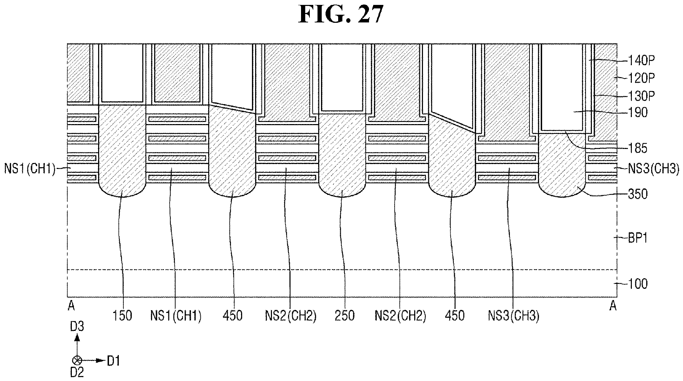

Referring to FIGS. 27 to 30, a part of the first pre-gate insulating film 130P and a part of the first pre-gate electrode 120P may be removed to form a first gate structure GS1 that surrounds the first sheet pattern NS 1.

While the first gate structure GS1 is being formed, a part of the first pre-gate spacer 140P may be etched. Accordingly, the first gate spacer 140 may be formed on the side wall of the first gate structure GS1.

By removing a part of the first pre-gate insulating film 130P and a part of the first pre-gate electrode 120P, a second pre-gate insulating film 130P1 and a second pre-gate electrode 120P1 that surround the second sheet pattern NS2 and the third sheet pattern NS3 may be formed. A part of the first pre-gate spacer 140P may be etched to form a second pre-gate spacer 140P1 on the side wall of the second pre-gate electrode 120P1.

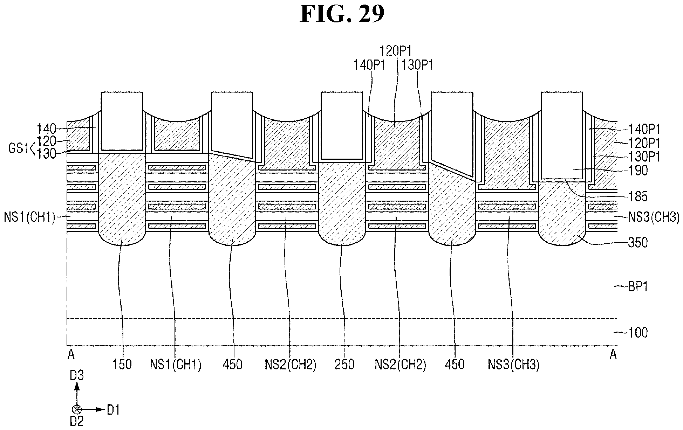

Referring to FIGS. 29 to 32, a gate recess mask RC_M may be formed on the first gate structure GS1, the second pre-gate insulating film 130P1, and the second pre-gate electrode 120P1.

The gate recess mask RC_M may include a first recess opening. The first recess opening may overlap the second channel pattern CH2 in the third direction D3.

The first gate recess process may be performed, using the gate recess mask RC_M including the first recess opening.

While the first gate recess process is in progress, a part of the second pre-gate insulating film 130P1 and a part of the second pre-gate electrode 120P1 may be etched. The second gate structure GS2 that surrounds the second sheet pattern NS2 may be formed accordingly.

While the second gate structure GS2 is being formed, a part of the second pre-gate spacer 140P1 may be etched. Accordingly, the second gate spacer 240 may be formed on the side wall of the second gate structure GS2.

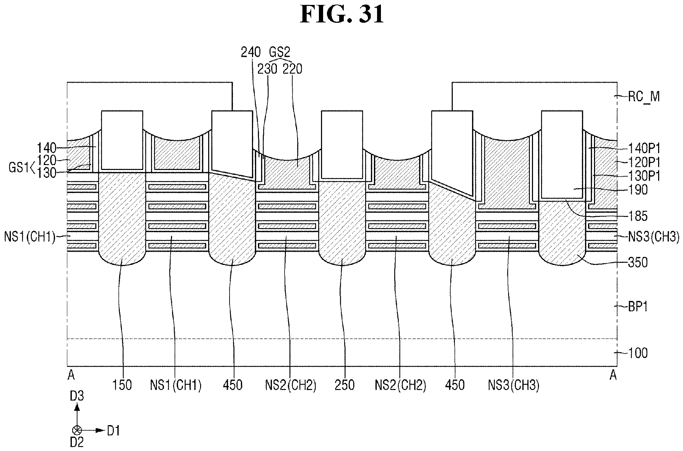

Referring to FIGS. 31 to 34, after forming the second gate structure GS2, the gate recess mask RC_M may partially or fully fill the space on the second gate structure GS2, using an additional recess mask material.

Subsequently, a gate recess mask RC_M including a second recess opening may be formed. The second recess opening may overlap the third channel pattern CH3 in the third direction D3.

A second gate recess process may be performed, using the gate recess mask RC_M including the second recess opening. While the second gate recess process is in progress, a part of the second pre-gate insulating film 130P1 and a part of the second pre-gate electrode 120P1 may be etched. The third gate structure GS3 that surrounds the third sheet pattern NS3 may be formed accordingly.

While the third gate structure GS3 is being formed, a part of the second pre-gate spacer 140P1 may be etched. Accordingly, the third gate spacer 340 may be formed on the side wall of the third gate structure GS3.

Subsequently, the gate recess mask RC_M including the second recess opening may be removed.

Next, referring to FIGS. 2 and 3, first to third gate capping patterns 145, 245, and 345 may be formed on the first to third gate structures GS1, GS2, and GS3.

In concluding the detailed description, those skilled in the art will appreciate that many variations and modifications may be made to the preferred embodiments without substantially departing from the principles of the present inventive concept. Therefore, the disclosed preferred embodiments of the invention are used in a generic and descriptive sense only and not for purposes of limitation.

Embodiments are set out in the following clauses:
1. A semiconductor device comprising:
   a lower pattern that extends in a first direction;
   a first channel pattern on the lower pattern, and includes a plurality of first sheet patterns spaced apart in a second direction that is different from the first direction;
   a second channel pattern on the lower pattern, includes a plurality of second sheet patterns spaced apart in the second direction, and is spaced apart from the first channel pattern in the first direction;
   a first gate structure which extends around the first sheet pattern in a plane including the first direction and the second direction, and includes a first gate electrode and a first gate insulating film;
   a second gate structure which extends around the second sheet pattern in the plane including the first direction and the second direction, and includes a second gate electrode and a second gate insulating film;
   a first gate capping pattern on the first gate structure; and
   a second gate capping pattern on the second gate structure,
   wherein a number of first sheet patterns is different from a number of second sheet patterns, and
   wherein a thickness of the first gate capping pattern is different from a thickness of the second gate capping pattern in the second direction.
2. The semiconductor device of clause 1,
   wherein the number of the first sheet patterns is greater than the number of the second sheet patterns, and the thickness of the first gate capping pattern is less than the thickness of the second gate capping pattern.
3. The semiconductor device of clause 2,
   wherein a distance from an upper surface of the lower pattern to an upper surface of the first gate capping pattern is same as a distance from the upper surface of the lower pattern to an upper surface of the second gate capping pattern.
4. The semiconductor device of any preceding clause,
   wherein a distance of from an upper surface of the lower pattern to a lower surface of the second gate capping pattern is different from a distance from the upper surface of the lower pattern to the lower surface of the second gate capping pattern.
5. The semiconductor device of any preceding clause,
   wherein the thickness of the first gate capping pattern in a portion overlapping the first channel pattern in the second direction is different from the thickness of the second gate capping pattern in a portion overlapping the second channel pattern in the second direction.
6. The semiconductor device of any preceding clause, further comprising:
   a source/drain pattern on the lower pattern and electrically connected to the first channel pattern and the second channel pattern,
   wherein the source/drain pattern is in contact with each of the first sheet patterns and each of the second sheet patterns.
7. The semiconductor device of clause 6,
   wherein the first gate structure includes a first outer gate structure on an upper surface of the first channel pattern,
   wherein the second gate structure includes a second outer gate structure on an upper surface of the second channel pattern,
   wherein the first gate insulating film of the first outer gate structure is spaced apart from the source/drain pattern, and
   wherein the second gate insulating film of the second outer gate structure is in contact with the source/drain pattern.
8. The semiconductor device of clause 6,
   wherein the first gate structure includes a first outer gate structure on an upper surface of the first channel pattern,
   wherein the second gate structure includes a second outer gate structure on the upper surface of the second channel pattern, and
   wherein the first gate insulating film of the first outer gate structure and the second gate insulating film of the second outer gate structure are in contact with the source/drain pattern.
9. The semiconductor device of any preceding clause, further comprising:
   a first gate contact which extends into the first gate capping pattern and is electrically connected to the first gate electrode, and a second gate contact which extends into the second gate capping pattern and is electrically connected to the second gate electrode,
   wherein a distance from an upper surface of the lower pattern to a lower surface of the first gate contact is equal to a distance from the upper surface of the lower pattern to a lower surface of the second gate contact.
10. The semiconductor device of clause 9,
   wherein the number of first sheet patterns is greater than the number of second sheet patterns, and
   wherein the second gate electrode includes a first portion and a second portion, and
   wherein the first portion of the second gate electrode overlaps the second channel pattern in the second direction, and a distance from the upper surface of the lower pattern to the upper surface of the first portion of the second gate electrode is less than a distance from the upper surface of the lower pattern to the upper surface of the second portion of the second gate electrode.
11. The semiconductor device of clause 10,
   wherein the second gate contact is electrically connected to the second portion of the second gate electrode.
12. A semiconductor device comprising:
   a lower pattern that extends in a first direction;
   a first channel pattern on the lower pattern, and includes a plurality of first sheet patterns spaced apart in a second direction that is different from the first direction;
   a second channel pattern on the lower pattern, includes a plurality of second sheet patterns spaced apart in the second direction, and is spaced apart from the first channel pattern in the first direction;
   a first gate electrode which extends around the first sheet pattern in a plane including the first direction and the second direction;
   a second gate electrode which extends around the second sheet pattern in the plane including the first direction and the second direction;
   a first gate capping pattern on the first gate electrode;
   a second gate capping pattern on the second gate electrode;
   a first gate contact which extends into the first gate capping pattern and is electrically connected to the first gate electrode; and
   a second gate contact which extends into the second gate capping pattern and is electrically connected to the second gate electrode,
   wherein a number of the first sheet patterns is different from a number of the second sheet patterns,
   wherein the first gate electrode includes a first portion of the first gate electrode that overlaps the first channel pattern in the second direction,
   wherein the second gate electrode includes a first portion of the second gate electrode that overlaps the second channel pattern in the second direction, and
   wherein a distance from an upper surface of the lower pattern to an upper surface of the first portion of the first gate electrode is different from a distance from the upper surface of the lower pattern to an upper surface of the first portion of the second gate electrode.
13. The semiconductor device of clause 12,
   wherein the number of the first sheet patterns is greater than the number of the second sheet patterns, and
   wherein a distance from the upper surface of the lower pattern to the upper surface of the first portion of the first gate electrode is greater than a distance from the upper surface of the lower pattern to the upper surface of the first portion of the second gate electrode.
14. The semiconductor device of clause 12 or clause 13,
   wherein a distance from the upper surface of the lower pattern to a lower surface of the first gate contact is same as a distance from the upper surface of the lower pattern to a lower surface of the second gate contact.
15. The semiconductor device of any of clauses 12 to 14,
   wherein the first gate electrode includes a second portion of the first gate electrode that is electrically connected to the first portion of the first gate electrode and does not overlap the first channel pattern in the second direction, and
   wherein the distance from the upper surface of the lower pattern to the upper surface of the first portion of the first gate electrode is less than a distance from the upper surface of the lower pattern to an upper surface of the second portion of the first gate electrode.
16. The semiconductor device of clause 15,
   wherein the first gate contact is in contact with the upper surface of the second portion of the first gate electrode.
17. The semiconductor device of clause 15 or clause 16,
   wherein the second gate electrode includes a second portion of the second gate electrode that is electrically connected to the first portion of the second gate electrode and does not overlap the second channel pattern in the second direction, and
   wherein the height distance from the upper surface of the lower pattern to the an upper surface of the second portion of the second gate electrode is equal to a height distance from the upper surface of the lower pattern to an upper surface of the second portion of the first gate electrode.
18. A semiconductor device comprising:
   a lower pattern extending in a first direction;
   a first channel pattern which is disposed on the lower pattern, and includes a plurality of first sheet patterns;
   a second channel pattern which is disposed on the lower pattern and includes a plurality of second sheet patterns, wherein the a number of the second sheet patterns included in the second channel pattern being smaller is less than the a number of the first sheet patterns included in the first channel pattern;
   a source/drain pattern which is disposed on the lower pattern and electrically connected to the first channel pattern and the second channel pattern;
   a first gate electrode which surrounds extends around the first sheet pattern in a cross-sectional view;
   a second gate electrode which surrounds extends around the second sheet pattern in the cross-sectional view;
   a first gate capping pattern on the first gate electrode; and
   a second gate capping pattern on the second gate electrode,
   wherein from viewpoint of a in the cross-sectional view, a height distance from an upper surface of the lower pattern to an upper surface of the first gate electrode is larger greater than a height distance from the upper surface of the lower pattern to an upper surface of the second gate electrode.
19. The semiconductor device of clause 18,
   wherein an upper surface of the first gate capping pattern is disposed on the a same plane with as an upper surface of the second gate capping pattern.
20. The semiconductor device of clause 18 or clause 19,
   wherein the an upper surface of the source/drain pattern has an inclined surface from viewpoint of in the cross-sectional view.

## Claims

1. A semiconductor device comprising:
a lower pattern that extends in a first direction;
a first channel pattern on the lower pattern, wherein the first channel pattern includes a plurality of first sheet patterns spaced apart in a second direction that is different from the first direction;
a second channel pattern on the lower pattern, wherein the second channel pattern includes a plurality of second sheet patterns spaced apart in the second direction, and is spaced apart from the first channel pattern in the first direction;
a first gate structure which extends around the first sheet pattern in a plane including the first direction and the second direction, and includes a first gate electrode and a first gate insulating film;
a second gate structure which extends around the second sheet pattern in the plane including the first direction and the second direction, and includes a second gate electrode and a second gate insulating film;
a first gate capping pattern on the first gate structure; and
a second gate capping pattern on the second gate structure,
wherein a number of first sheet patterns is different from a number of second sheet patterns, and
wherein a thickness of the first gate capping pattern is different from a thickness of the second gate capping pattern in the second direction.

2. The semiconductor device of claim 1,
wherein the number of the first sheet patterns is greater than the number of the second sheet patterns, and the thickness of the first gate capping pattern is less than the thickness of the second gate capping pattern.

3. The semiconductor device of claim 2,
wherein a distance from an upper surface of the lower pattern to an upper surface of the first gate capping pattern is same as a distance from the upper surface of the lower pattern to an upper surface of the second gate capping pattern.

4. The semiconductor device of any preceding claim,
wherein a distance of from an upper surface of the lower pattern to a lower surface of the second gate capping pattern is different from a distance from the upper surface of the lower pattern to the lower surface of the second gate capping pattern.

5. The semiconductor device of any preceding claim,
wherein the thickness of the first gate capping pattern in a portion overlapping the first channel pattern in the second direction is different from the thickness of the second gate capping pattern in a portion overlapping the second channel pattern in the second direction.

6. The semiconductor device of any preceding claim, further comprising:
a source/drain pattern on the lower pattern and electrically connected to the first channel pattern and the second channel pattern,
wherein the source/drain pattern is in contact with each of the first sheet patterns and each of the second sheet patterns.

7. The semiconductor device of claim 6,
wherein the first gate structure includes a first outer gate structure on an upper surface of the first channel pattern,
wherein the second gate structure includes a second outer gate structure on an upper surface of the second channel pattern,
wherein the first gate insulating film of the first outer gate structure is spaced apart from the source/drain pattern, and
wherein the second gate insulating film of the second outer gate structure is in contact with the source/drain pattern.

8. The semiconductor device of claim 6,
wherein the first gate structure includes a first outer gate structure on an upper surface of the first channel pattern,
wherein the second gate structure includes a second outer gate structure on the upper surface of the second channel pattern, and
wherein the first gate insulating film of the first outer gate structure and the second gate insulating film of the second outer gate structure are in contact with the source/drain pattern.

9. The semiconductor device of any preceding claim, further comprising:
a first gate contact which extends into the first gate capping pattern and is electrically connected to the first gate electrode, and a second gate contact which extends into the second gate capping pattern and is electrically connected to the second gate electrode,
wherein a distance from an upper surface of the lower pattern to a lower surface of the first gate contact is equal to a distance from the upper surface of the lower pattern to a lower surface of the second gate contact.

10. The semiconductor device of claim 9,
wherein the number of first sheet patterns is greater than the number of second sheet patterns, and
wherein the second gate electrode includes a first portion and a second portion, and
wherein the first portion of the second gate electrode overlaps the second channel pattern in the second direction, and a distance from the upper surface of the lower pattern to the upper surface of the first portion of the second gate electrode is less than a distance from the upper surface of the lower pattern to the upper surface of the second portion of the second gate electrode.

11. The semiconductor device of claim 10,
wherein the second gate contact is electrically connected to the second portion of the second gate electrode.

12. A semiconductor device comprising:
a lower pattern that extends in a first direction;
a first channel pattern on the lower pattern, wherein the first channel pattern includes a plurality of first sheet patterns spaced apart in a second direction that is different from the first direction;
a second channel pattern on the lower pattern, wherein the second channel pattern includes a plurality of second sheet patterns spaced apart in the second direction, and is spaced apart from the first channel pattern in the first direction;
a first gate electrode which extends around the first sheet pattern in a plane including the first direction and the second direction;
a second gate electrode which extends around the second sheet pattern in the plane including the first direction and the second direction;
a first gate capping pattern on the first gate electrode;
a second gate capping pattern on the second gate electrode;
a first gate contact which extends into the first gate capping pattern and is electrically connected to the first gate electrode; and
a second gate contact which extends into the second gate capping pattern and is electrically connected to the second gate electrode,
wherein a number of the first sheet patterns is different from a number of the second sheet patterns,
wherein the first gate electrode includes a first portion of the first gate electrode that overlaps the first channel pattern in the second direction,
wherein the second gate electrode includes a first portion of the second gate electrode that overlaps the second channel pattern in the second direction, and
wherein a distance from an upper surface of the lower pattern to an upper surface of the first portion of the first gate electrode is different from a distance from the upper surface of the lower pattern to an upper surface of the first portion of the second gate electrode.

13. The semiconductor device of claim 12,
wherein the number of the first sheet patterns is greater than the number of the second sheet patterns, and
wherein a distance from the upper surface of the lower pattern to the upper surface of the first portion of the first gate electrode is greater than a distance from the upper surface of the lower pattern to the upper surface of the first portion of the second gate electrode.

14. The semiconductor device of claim 12 or claim 13,
wherein a distance from the upper surface of the lower pattern to a lower surface of the first gate contact is same as a distance from the upper surface of the lower pattern to a lower surface of the second gate contact.

15. The semiconductor device of any of claims 12 to 14,
wherein the first gate electrode includes a second portion of the first gate electrode that is electrically connected to the first portion of the first gate electrode and does not overlap the first channel pattern in the second direction, and
wherein the distance from the upper surface of the lower pattern to the upper surface of the first portion of the first gate electrode is less than a distance from the upper surface of the lower pattern to an upper surface of the second portion of the first gate electrode.
